# EUROPEAN PATENT APPLICATION

(11) **EP 4 703 498 A1**
(43) Date of publication of application: **04.03.2026**
(21) Application number: 25195842.7
(22) Date of filing: 14.08.2025
(51) Int. Cl.: C25B 1/04, C25B 15/02

(54) **DIAGNOSIS METHOD OF ELECTROLYTIC UNIT, DIAGNOSIS METHOD OF ELECTROLYTIC APPARATUS, DIAGNOSIS APPARATUS OF ELECTROLYTIC UNIT, OPERATION SYSTEM, AND DIAGNOSIS PROGRAM OF ELECTROLYTIC UNIT**

(30) Priority: 30.08.2024 JP 2024149865
(71) Applicant: KABUSHIKI KAISHA TOSHIBA, Kawasaki-shi, Kanagawa (JP)
(72) Inventor: Uno, Wataru, Kawasaki-shi, Kanagawa (JP); Morimoto, Sayaka, Kawasaki-shi, Kanagawa (JP); Yagi, Ryosuke, Kawasaki-shi, Kanagawa (JP); Yoshinaga, Norihiro, Kawasaki-shi, Kanagawa (JP)
(74) Representative: Hoffmann Eitle

(57) **Abstract**

In an approach, a diagnosis method of an electrolytic unit (2) in which an electrochemical reaction occurs with a feed supplied by input of electric power is provided. In the diagnosis method, for the electrolytic unit (2), each of a membrane resistance (Rm) caused by a membrane, an anode resistance (Ra) caused by an anode, and a cathode resistance (Rc) caused by a cathode is estimated based on a measurement result of a frequency characteristic of an impedance. In the diagnosis method, an operation status and a deterioration state of the electrolytic unit (2) are determined based on time changes of the membrane resistance (Rm), the anode resistance (Ra), and the cathode resistance (Rc) .

## Description

### FIELD

Disclosures described herein relate generally to a diagnosis method of an electrolytic unit, a diagnosis method of an electrolytic apparatus, a diagnosis apparatus of the electrolytic unit, an operation system, and a diagnosis program of the electrolytic unit.

### BACKGROUND

An electrolytic unit is used in which an electrochemical reaction using a feed is generated by input of electric power in a state where the feed is supplied. For example, in an electrolytic unit (water electrolysis unit) to which water is supplied as a feed, electrolysis of water occurs as an electrochemical reaction by input of electric power. Hydrogen or the like is generated as a product by the electrochemical reaction in the electrolytic unit, and the generated hydrogen or the like is recovered.

In the electrolytic unit as described above, if the operation is continued, material deterioration or the like occurs, and the deterioration progresses. In addition, in a state where the electrolytic unit is operated, an operation abnormality such as overheating, overcurrent, and insufficient supply of a feed may occur in the electrolytic unit. For this reason, in a state where the electrolytic unit is operated, for example, it is required to appropriately grasp a deterioration state and an operation status of the electrolytic unit by appropriately grasping occurrence of material deterioration, operation abnormality, and the like.

### BRIEF DESCRIPTION OF THE DRAWINGS

FIG. 1 is a schematic diagram illustrating an example of an operation system according to a first approach.
FIG. 2 is a flowchart schematically illustrating an example of processing of estimating a resistance component of an electrolytic unit performed by a processing circuit or the like in the first approach.
FIG. 3 is a schematic diagram illustrating an example of an equivalent circuit of an equivalent circuit model used for estimating a plurality of resistance components of an electrolytic unit in the first approach.
FIG. 4 is a schematic diagram illustrating an example of processing of estimating a plurality of resistance components of an electrolytic unit performed by a processing circuit or the like in the first approach.
FIG. 5 is a flowchart schematically illustrating an example of determination processing regarding an operation status and a deterioration state of the electrolytic unit performed by the processing circuit or the like in the first approach.
FIG. 6 is a schematic diagram illustrating a verification result in verification related to the first approach and the like.
FIG. 7 is a flowchart schematically illustrating an example of determination processing regarding an operation status and a deterioration state of the electrolytic unit performed by a processing circuit or the like in a first modification.
FIG. 8 is a flowchart schematically illustrating an example of processing related to input of a diagnosis current to the electrolytic unit performed by a processing circuit or the like in a third modification.
FIG. 9 is a schematic diagram illustrating an example of timing of inputting the diagnosis current to the electrolytic unit in the third modification.
FIG. 10 is a schematic view showing a configuration of an electrolytic apparatus according to a fourth modification.

### DETAILED DESCRIPTION

In an approach, a diagnosis method of an electrolytic unit in which an electrochemical reaction occurs with a feed supplied by input of electric power is provided. In the diagnosis method, for the electrolytic unit, each of the membrane resistance caused by the membrane, the anode resistance caused by the anode, and the cathode resistance caused by the cathode is estimated based on the measurement result of the frequency characteristic of the impedance. In the diagnosis method, the operation status and the deterioration state of the electrolytic unit are determined based on time changes of the membrane resistance, the anode resistance, and the cathode resistance.

Hereinafter, an approach will be described with reference to the drawings.

### (First Approach)

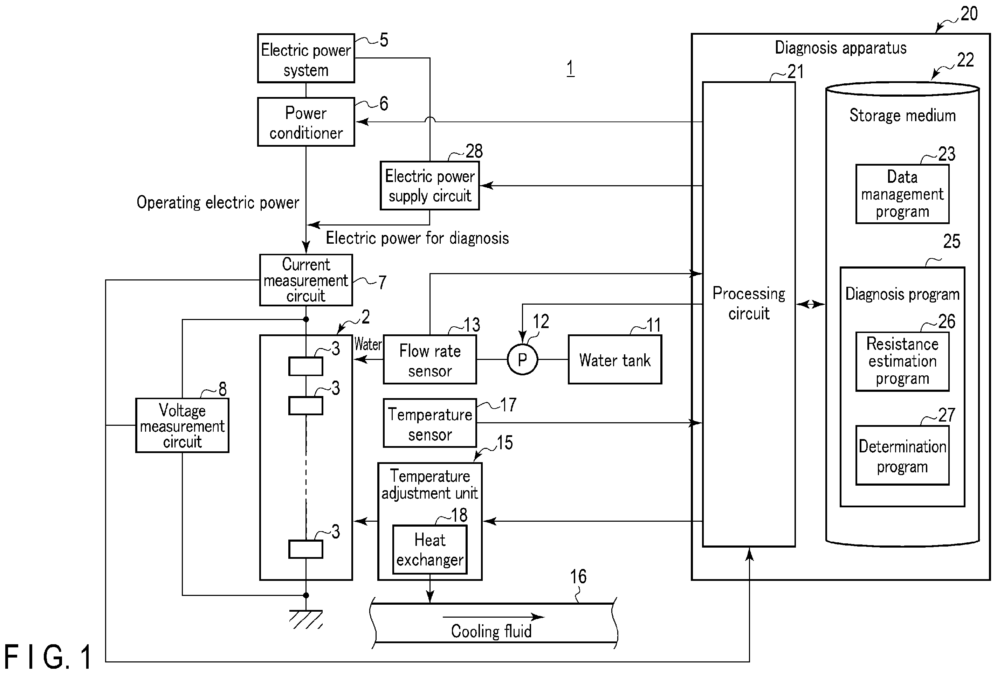

First, as an example of an approach, a first approach will be described. FIG. 1 is a schematic diagram illustrating an example of an operation system 1 according to the first approach. As illustrated in FIG. 1, the operation system 1 includes an electrolytic unit 2, and the electrolytic unit 2 is operated in the operation system 1. In the example of FIG. 1, the electrolytic unit 2 is composed of an electrolytic block or an electrolytic module in which a plurality of electrolytic cells 3 are electrically connected. In the electrolytic unit 2, at least one of a series connection structure in which the plurality of electrolytic cells 3 are electrically connected in series and a parallel connection structure in which the plurality of electrolytic cells 3 are electrically connected in parallel is formed. In one example, the electrolytic unit 2 may be formed of a single electrolytic cell 3.

The electrolytic cell 3 constituting the electrolytic unit 2 includes an anode and a cathode. In the electrolytic cell 3, a membrane such as an ion exchange membrane or an electrolyte membrane is interposed between the anode and the cathode. In addition, in the electrolytic cell 3, at least one of the anode and the cathode may include a catalyst, and both the anode and the cathode may include a catalyst. In the electrolytic cell 3, as the catalyst of the cathode, for example, a metal or an alloy containing any element such as Pt, Ru, Rh, Pd, Au, Os, or Ir is used, and as the catalyst of the anode, for example, a metal, an alloy, or an oxide containing any element such as Ir, Ru, Rh, Pd, Au, or Os is used.

The electrolytic unit 2 can be connected to an electric power system 5, and electric power is input from the electric power system 5 to the electrolytic unit 2 during operation of the electrolytic unit 2. Examples of the electric power system 5 include an electric power system that supplies electric power from a generator that generates electric power using natural energy such as sunlight and wind power, and an electric power system that supplies electric power from a power plant.

The operation system 1 is provided with a power conditioner 6 as a power adjustment unit. The power conditioner 6 converts electric power from the power system 5, and inputs the converted electric power to the electrolytic unit 2 as operating electric power. At this time, the power conditioner 6 converts, for example, AC electric power from the electric power system 5 into DC electric power having a voltage range corresponding to the electrolytic unit 2 by AC/DC conversion and transformation, and inputs the converted DC electric power to the electrolytic unit 2. In the operation system 1, the magnitude of the electric power input to the electrolytic unit 2 as the operating electric power changes in accordance with the operating state of the power conditioner 6. Therefore, the magnitude of the operating current (current) input to the electrolytic unit 2 and the magnitude of the voltage applied to the electrolytic unit 2 are changed in accordance with the operating state of the power conditioner 6, and the current and the voltage of the electrolytic unit 2 are adjusted by the power conditioner 6.

A feed is supplied to the electrolytic unit 2, and in one example of FIG. 1, water is supplied to the electrolytic unit 2 as a feed. The electrolytic unit 2 is a water electrolysis unit, and each of the electrolytic cells 3 constituting the electrolytic unit 2 is a water electrolysis cell. In the operation of the electrolytic unit 2, electric power is input to the electrolytic unit 2 in a state where a feed is supplied to the electrolytic unit 2. In a state where the feed is supplied, electric power is input to the electrolytic unit 2, whereby an electrochemical reaction using the feed occurs in the electrolytic unit 2. In the example of FIG. 1, when electric power is input to the electrolytic unit 2, electrolysis of water occurs as an electrochemical reaction in each of the electrolytic cells 3 constituting the electrolytic unit 2.

In a state where an electrochemical reaction such as electrolysis of water occurs in the electrolytic unit 2 by the input of electric power to the electrolytic unit 2, in each of the electrolytic cells 3 constituting the electrolytic unit 2, the anode has a relatively higher electric potential than the cathode. At this time, in each of the electrolytic cells 3, the electric potentials of the anode and the cathode change in accordance with to the material constituting the electrode, the operating conditions of the electrolytic unit 2, and the like. In each of the electrolytic cells 3, at least hydrogen ions and oxygen are generated at the anode in a state where electrolysis of water is performed, that is, in a state where the electrolytic unit 2 is operated. In each of the electrolytic cells 3, hydrogen ions generated at the anode move to the cathode side through the membrane, and hydrogen is generated at the cathode. In the electrolytic unit 2, a product generated by an electrochemical reaction is recovered, and in one example of FIG. 1, hydrogen which is a product generated by electrolysis of water is recovered.

The operation system 1 is provided with a current measurement circuit 7 and a voltage measurement circuit 8. The current measurement circuit 7 includes, for example, a current sensor and the like, and the voltage measurement circuit 8 includes, for example, a voltage sensor and the like. In a state where the operating electric power is input to the electrolytic unit 2 or the like, the current measurement circuit 7 measures the current of the electrolytic unit 2, that is, the current input to the electrolytic unit 2. In addition, in a state where the operating electric power is input to the electrolytic unit 2 or the like, the voltage measurement circuit 8 measures the voltage of the electrolytic unit 2, that is, the voltage applied to the electrolytic unit 2.

In addition, the operation system 1 includes a water tank 11, a supply pump 12, and a flow rate sensor 13. The water tank 11 stores water as a feed to the electrolytic unit 2. Water in the water tank 11 is supplied to the electrolytic unit 2 by operation of the supply pump 12. The supply state of water to the electrolytic unit 2, including the supply amount of water to the electrolytic unit 2, changes in accordance with the operating state of the supply pump 12. For example, the flow rate sensor 13 detects a flow rate of water supplied from the supply pump 12 to the electrolytic unit 2 to detect a supply amount of water as a feed to the electrolytic unit 2.

In addition, the operation system 1 is provided with a temperature adjustment unit 15, a flow path 16, and a temperature sensor 17, and the temperature adjustment unit 15 includes a heat exchanger 18. A cooling fluid such as cooling water or cooling gas flows through the flow path 16. The temperature adjustment unit 15 adjusts the temperature of the electrolytic unit 2 by, for example, transferring heat between the cooling fluid flowing through the flow path 16 and the electrolytic unit 2 using the heat exchanger 18. The temperature of the electrolytic unit 2 changes in accordance with the operating state of the temperature adjustment unit 15 including the heat exchanger 18. The temperature sensor 17 detects a temperature of the electrolytic unit 2.

In the present approach, the operation system 1 includes a diagnosis apparatus 20 serving as a processing apparatus. The diagnosis apparatus 20 performs processing related to diagnosis of the operating electrolytic unit 2. Therefore, in the operation system 1, the electrolytic unit 2 is a diagnosis target of diagnosis by the diagnosis apparatus 20. In the example of FIG. 1, the diagnosis apparatus 20 is constituted by a computer such as a server, and includes a processing circuit 21 and a storage medium (non-transitory storage medium) 22.

The processing circuit 21 includes a processor, an integrated circuit, or the like, and the processor or the like constituting the processing circuit 21 includes any of a central processing unit (CPU), an application specific integrated circuit (ASIC), a microcomputer, a field programmable gate array (FPGA), a digital signal processor (DSP), and the like. The processing circuit 21 may include a processor or the like, or may include a plurality of processors or the like. Furthermore, the storage medium 22 may be a main storage apparatus such as a memory, or may be an auxiliary storage apparatus. In the diagnosis apparatus 20, only one storage medium 22 may be provided, or a plurality of storage media may be provided.

In the diagnosis apparatus 20, the processing circuit 21 performs processing by executing a program or the like stored in the storage medium 22. Furthermore, the storage medium 22 stores data and the like used for processing in the processing circuit 21. In one example, in the diagnosis apparatus 20, the program executed by the processing circuit 21 may be stored in a computer (server) connected via a network such as the Internet, a server in a cloud environment, or the like. In this case, the processing circuit 21 downloads the program via the network.

In the example of FIG. 1, the storage medium (non-transitory storage medium) 22 stores a data management program 23 and a diagnosis program 25 as programs to be executed by the processing circuit 21. The processing circuit 21 executes the data management program 23 to write data to the storage medium 22 and read data from the storage medium 22. The diagnosis program 25 includes a resistance estimation program 26 and a determination program 27. In the diagnosis of the electrolytic unit 2, the processing circuit 21 performs processing to be described later based on the diagnosis program 25.

In one example, the diagnosis apparatus 20 includes a plurality of computers such as a plurality of servers, and the processors of the plurality of computers cooperate to perform processing and the like described later based on the diagnosis program 25. In a case where the diagnosis apparatus 20 includes a plurality of computers, the plurality of computers constituting the diagnosis apparatus 20 can communicate with each other wirelessly or by wire.

In another example, at least a part of the diagnosis apparatus 20 is configured from a cloud server in a cloud environment. The infrastructure of the cloud environment includes a virtual processor such as a virtual CPU and a cloud memory. In a case where at least a part of the diagnosis apparatus 20 is constituted by a cloud server, a virtual processor performs at least a part of processing and the like described later based on the diagnosis program 25. In addition, a program executed by the virtual processor, data used for processing in the virtual processor, and the like are stored in the cloud memory.

In one example, the diagnosis apparatus 20 may be provided with a user interface. In this case, in the user interface, various operations including operations related to the operation and diagnosis of the electrolytic unit 2 are input by the user or the like of the operation system 1. Therefore, in the user interface, any of a button, a mouse, a touch panel, a keyboard, and the like is provided as an operation unit to which an operation is input by the user or the like. In addition, the user interface is provided with a notification unit that notifies information related to the electrolytic unit 2. The notification unit notifies information by any of screen display, transmission of sound, and the like. Note that the user interface may be provided separately from a computer or the like constituting the diagnosis apparatus 20. Furthermore, the user interface is not necessarily provided.

In the example of FIG. 1, the processing circuit 21 and the like of the diagnosis apparatus 20 acquire the measurement result of the current of the electrolytic unit 2 in the current measurement circuit 7 and the measurement result of the voltage of the electrolytic unit 2 in the voltage measurement circuit 8. Then, the processing circuit 21 and the like control operation of the power conditioner 6 based on the measurement results of the current and the voltage of the electrolytic unit 2 to adjust the magnitude of the operating electric power input to the electrolytic unit 2 and the like. As a result, an operating current input to the electrolytic unit 2, a voltage applied to the electrolytic unit 2, and the like are adjusted.

In the example of FIG. 1, the processing circuit 21 and the like acquire a detection result of the supply amount of water by the flow rate sensor 13. Then, the processing circuit 21 and the like control the operation of the supply pump 12 based on the detection result of the supply amount of water to the electrolytic unit 2, and adjust the flow rate and the like of the water supplied to the electrolytic unit 2. The processing circuit 21 and the like acquire a detection result of the temperature of the electrolytic unit 2 by the temperature sensor 17. Then, the processing circuit 21 and the like control the operation of the temperature adjustment unit 15 including the heat exchanger 18 based on the detection result of the temperature of the electrolytic unit 2, and adjust the temperature of the electrolytic unit 2.

In addition, the operation system 1 is provided with an electric power supply circuit 28 for diagnosis. In the diagnosis of the electrolytic unit 2, the electric power supply circuit 28 converts, for example, electric power from the electric power system 5 into electric power for diagnosis, and generates electric power for diagnosis used for the diagnosis of the electrolytic unit 2. In the diagnosis of the electrolytic unit 2, the processing circuit 21 and the like input the electric power for diagnosis to the electrolytic unit 2 by controlling the operation of the electric power supply circuit 28. The electric power for diagnosis is input to the electrolytic unit 2, whereby the diagnosis current is input to the electrolytic unit 2. In a state where the electric operating power is input to the electrolytic unit 2, the electric power for diagnosis from the electric power supply circuit 28 is input to the electrolytic unit 2, so that a diagnosis current is superimposed on the operating current input to the electrolytic unit 2.

In the present approach, the processing circuit 21 or the like executes the diagnosis program 25, so that the diagnosis processing is repeated over time for the operating electrolytic unit 2. In one example, the diagnosis processing is periodically performed on the electrolytic unit 2 to be diagnosed. In one-time diagnosis processing for the electrolytic unit 2, the resistance component estimation processing of the electrolytic unit 2 is performed by executing the resistance estimation program 26 included in the diagnosis program 25.

In one-time diagnosis processing for the electrolytic unit 2, after the resistance component estimation processing is performed, the determination program 27 included in the diagnosis program 25 is executed, so that the determination processing based on the estimation result of the resistance component is performed for the electrolytic unit 2. In the determination processing for the electrolytic unit 2, the operation status and the deterioration state of the electrolytic unit 2 are determined. As the diagnosis processing as described above is repeatedly performed over time, the resistance component estimation processing and the determination processing regarding the operation status and the deterioration state are repeatedly performed over time for the operating electrolytic unit 2.

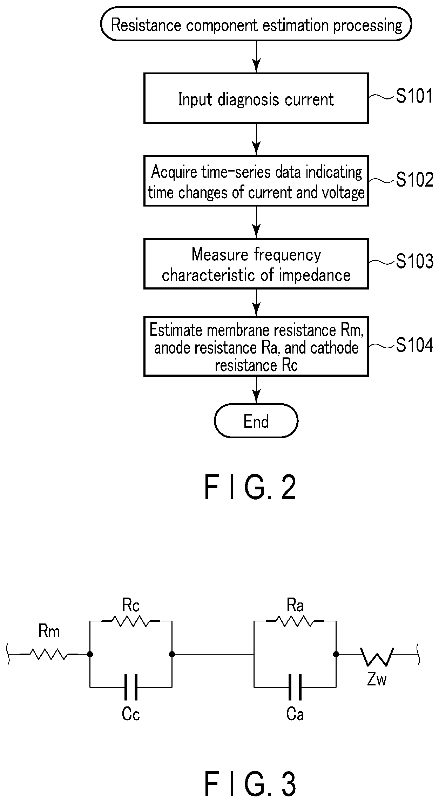

FIG. 2 is a flowchart schematically showing an example of resistance component estimation processing of the electrolytic unit 2 performed by the processing circuit 21 and the like in the first approach. The estimation processing in the example of FIG. 2 is performed before the later-described determination processing related to the operation status and the deterioration state of the electrolytic unit 2 is executed in each diagnosis processing on the electrolytic unit 2 repeatedly performed over time. When the processing of the example of FIG. 2 is started, the processing circuit 21 or the like controls driving of the electric power supply circuit 28 or the like to input a diagnosis current from the electric power supply circuit 28 to the electrolytic unit 2 (S101). The diagnosis current is a current signal corresponding to the measurement of the impedance of the electrolytic unit 2.

In one example, as a diagnosis current, an alternating current with a periodically changing current value is input to the electrolytic unit 2. In this case, the alternating current is input to the electrolytic unit 2 with any waveform such as a sine wave, a triangular wave, or a sawtooth wave. In a case where the alternating current is generated as the diagnosis current, the processing circuit 21 or the like adjusts the frequency of the alternating current input to the electrolytic unit 2 by controlling the driving of the electric power supply circuit 28 or the like. Then, the processing circuit 21 and the like input an alternating current to be a diagnosis current to the electrolytic unit 2 in a state where the alternating current changes to a plurality of frequencies with time. In another example, a pseudo random pulse signal such as an M-sequence signal is input to the electrolytic unit 2 as a diagnosis current. In this case, the pseudo random pulse signal input to the electrolytic unit 2 includes a plurality of types of pulses having different pulse widths from each other.

Then, in a state where the diagnosis current is input to the electrolytic unit 2, the processing circuit 21 and the like cause the current measurement circuit 7 to measure the current of the electrolytic unit 2, and cause the voltage measurement circuit 8 to measure the voltage of the electrolytic unit 2. Then, the processing circuit 21 and the like acquire time-series data indicating time changes (time history) of the current and the voltage of the electrolytic unit 2 in a state where the diagnosis current is input to the electrolytic unit 2 (S102). The time change in the current of the electrolytic unit 2 indicated by the time-series data is generated based on the measurement result in the current measurement circuit 7, and the time change in the voltage of the electrolytic unit 2 indicated by the time-series data is generated based on the measurement result in the voltage measurement circuit 8.

In one example, in a state in which an operating current is input to the electrolytic unit 2, that is, in a state in which an electrochemical reaction occurs in the electrolytic unit 2 due to the input of the operating electric power, a diagnosis current is input to the electrolytic unit 2. In this case, the diagnosis current corresponding to the measurement of the impedance is superimposed on the operating current input to the electrolytic unit 2 in order to generate the electrochemical reaction. Therefore, in parallel with the operation of the electrolytic unit 2, the time series data indicating the time changes of the current and the voltage of the electrolytic unit 2 in the state where the diagnosis current is input is measured.

When the above-described time-series data (measurement data) is acquired, the processing circuit 21 or the like measures the frequency characteristic of the impedance of the electrolytic unit 2 by analyzing the acquired time-series data (S103). When the time-series data is acquired, the input of the diagnosis current to the electrolytic unit 2 is stopped. In one example, in the measurement of the frequency characteristic of the impedance of the electrolytic unit 2, the time change of the current of the electrolytic unit 2 indicated by the above-described time-series data, that is, the current time-series data included in the time-series data is Fourier-transformed to generate current spectrum data indicating the frequency characteristic of the current of the electrolytic unit 2. The voltage spectrum data indicating the frequency characteristic of the voltage of the electrolytic unit 2 is generated by performing the Fourier transform on the time change of the voltage of the electrolytic unit 2 indicated by the above-described time-series data, that is, the voltage time-series data included in the time-series data.

Then, calculation is performed using the current spectrum data and the voltage spectrum data of the electrolytic unit 2 to calculate impedance spectrum data indicating a frequency characteristic of impedance of the electrolytic unit 2. The impedance spectrum data of the electrolytic unit 2 is calculated, for example, by dividing voltage spectrum data of the electrolytic unit 2 by the current spectrum data of the electrolytic unit 2. In the impedance spectrum data of the electrolytic unit 2, the impedance of the electrolytic unit 2 at each of the plurality of frequencies is indicated.

A method for calculating the frequency characteristic of the impedance of the battery using the current time-series data on the current of the battery and the voltage time-series data on the voltage of the battery is disclosed in Reference Literature 1 (Japanese Patent Application Laid-Open No. 2014 -126532). In the approach and the like, the frequency characteristic of the impedance of the electrolytic unit 2 may be calculated in the same manner as the calculation of the frequency characteristic of the impedance of the battery in Reference Literature 1. In this case, the processing circuit 21 and the like calculate an autocorrelation function of the current spectrum data of the electrolytic unit 2, and calculate a cross-correlation function between the current spectrum data and the voltage spectrum data of the electrolytic unit 2. Then, the processing circuit 21 and the like calculate the frequency characteristic of the impedance of the electrolytic unit 2 using the calculated autocorrelation function and cross-correlation function.

In one example, an alternating current is input as a diagnosis current to the electrolytic unit 2 at a plurality of frequencies, and the processing circuit 21 and the like calculate the impedance of the electrolytic unit 2 based on the current value and the voltage value of the electrolytic unit 2 indicated by time-series data (measurement data) or the like for each of the plurality of frequencies. At this time, for example, the impedance of the electrolytic unit 2 is calculated by dividing the voltage value of the electrolytic unit 2 by the current value for each of the plurality of frequencies. As a result, the frequency characteristic of the impedance of the electrolytic unit 2 in which the impedance of the electrolytic unit 2 at each of the plurality of frequencies is indicated is calculated.

When the frequency characteristic of the impedance of the electrolytic unit 2 is measured, the processing circuit 21 and the like estimate each of the membrane resistance Rm, the anode resistance Ra, and the cathode resistance Rc as a resistance component based on the measurement result of the frequency characteristic of the impedance for the electrolytic unit 2 (S104). The membrane resistance Rm is a resistance component caused by the membrane of the electrolytic cell 3 constituting the electrolytic unit 2. The anode resistance Ra is a resistance component caused by the anode of the electrolytic cell 3 constituting electrolytic unit 2, and is mainly a resistance component caused by the catalyst of the anode. The cathode resistance Rc is a resistance component caused by the cathode of the electrolytic cell 3 constituting electrolytic unit 2, and is mainly a resistance component caused by the catalyst of the cathode.

Estimation of the plurality of resistance components of the electrolytic unit 2, that is, estimation of the membrane resistance Rm, the anode resistance Ra, and the cathode resistance Rc of the electrolytic unit 2 is performed using, for example, a measurement result of a frequency characteristic of impedance of the electrolytic unit 2 and an equivalent circuit model of the electrolytic unit 2. The equivalent circuit model of the electrolytic unit 2 is stored in the storage medium 22 or the like, and the equivalent circuit model indicates an equivalent circuit of the electrolytic unit 2. In the equivalent circuit of the equivalent circuit model, circuit parameters (electrical characteristic parameters) including the resistance component to be estimated are set. Therefore, in the equivalent circuit, circuit parameters including the membrane resistance Rm, the anode resistance Ra, and the cathode resistance Rc are set.

FIG. 3 is a schematic diagram illustrating an example of an equivalent circuit of an equivalent circuit model used for estimating a plurality of resistance components of the electrolytic unit 2 in the first approach. In the equivalent circuit of the example of FIG. 3, the membrane resistance Rm, the anode resistance Ra, and the cathode resistance Rc are set as the circuit parameters. In addition, in the equivalent circuit of the example of FIG. 3, the capacitance Ca that is a capacitance component caused by the anode and the capacitance Cc that is a capacitance component caused by the cathode are also set as circuit parameters. Then, a warburg impedance Zw, which is an impedance in a diffusion process of ions such as hydrogen ions, is set as a circuit parameter. In the electrolytic unit 2, the resistance component of the warburg impedance Zw is a diffusion resistance.

In the equivalent circuit model used for estimating the plurality of resistance components of the electrolytic unit 2, the relationship between the circuit parameter set in the equivalent circuit and the impedance of the electrolytic unit 2 is shown, and for example, a relational expression for calculating the impedance of the electrolytic unit 2 using the circuit parameter and the frequency is shown. In the estimation of the membrane resistance Rm, the anode resistance Ra, and the cathode resistance Rc of the electrolytic unit 2, the processing circuit 21 and the like perform fitting calculation using, for example, the relationship between the circuit parameter and the impedance indicated by the equivalent circuit model and the measurement result of the frequency characteristic of the impedance of the electrolytic unit 2.

In the fitting calculation using the equivalent circuit model, calculation is performed using a circuit parameter set in an equivalent circuit including a plurality of resistance components to be estimated as a variable, and a circuit parameter to be a variable is calculated. In addition, in the fitting calculation, the value of the circuit parameter to be a variable is calculated in a state where the difference between the calculated value of the impedance calculated using the relationship indicated by the equivalent circuit model and the measured value of the impedance, which is the measurement result, is as small as possible at each of the plurality of frequencies at which the impedance is measured. By calculating the circuit parameters by fitting calculation, the membrane resistance Rm, the anode resistance Ra, and the cathode resistance Rc are calculated as a plurality of resistance components for the electrolytic unit 2.

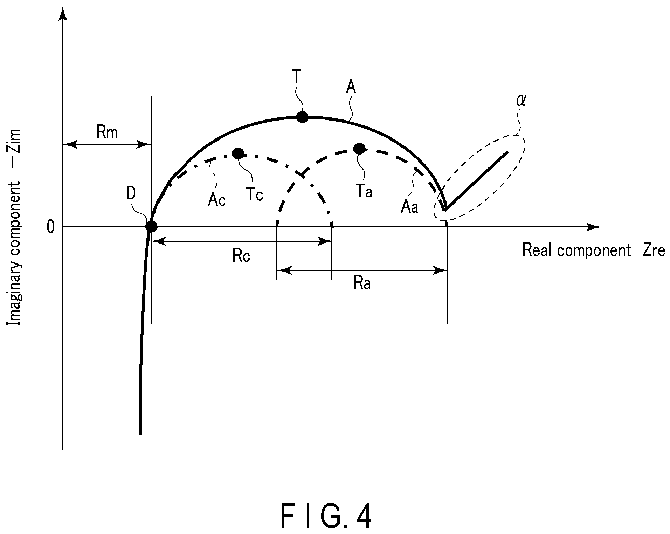

FIG. 4 is a schematic diagram illustrating an example of processing of estimating a plurality of resistance components of the electrolytic unit 2 performed by the processing circuit 21 and the like in the first approach. FIG. 4 illustrates a graph in which the abscissa axis represents the real component Zre of the impedance and the ordinate axis represents the imaginary component -Zim of the impedance. Therefore, in FIG. 4, the measurement result of the frequency characteristic of the impedance of the electrolytic unit 2 is indicated by a complex impedance plot (Cole-Cole plot). In FIG. 4, the measurement result of the frequency characteristic of the impedance of the electrolytic unit 2 is indicated by a solid line.

As shown in FIG. 4, in the complex impedance plot showing the measurement result of the frequency characteristic of the impedance of the electrolytic unit 2, an arc portion A convex to the negative side of the imaginary component of the impedance is formed. The arc portion A has a vertex T of the convex shape, and the imaginary component of the impedance has a negative value at the vertex T of the convex shape. In addition, in the complex impedance plot, there is an intersection D intersecting with the abscissa axis, which is the axis of the real component, on the side where the frequency is higher with respect to the vertex T of the convex shape of the arc portion A.

In the example of FIG. 4, the value (positive value) of the real component of the impedance at the intersection D of the complex impedance plot is calculated as the membrane resistance Rm of the electrolytic unit 2 by performing the fitting calculation using the equivalent circuit model as described above. In addition, in the complex impedance plot of the example of FIG. 4, the impedance component on the side where the frequency is lower with respect to the arc portion A, that is, the impedance component of a region α corresponds to the warburg impedance.

By performing the fitting calculation using the equivalent circuit model as described above, the anode impedance caused by the anode and the cathode impedance caused by the cathode are separated from the complex impedance plot indicating the measurement result of the frequency characteristic of the impedance of the electrolytic unit 2. As a result, the arc portion A of the complex impedance plot is separated into an arc portion Aa indicating the anode impedance and an arc portion Ac indicating the cathode impedance. In FIG. 4, the arc portion Aa of the anode impedance is indicated by a broken line, and the arc portion Ac of the cathode impedance is indicated by an alternate long and short dash line.

In the example of FIG. 4, by performing fitting calculation using the equivalent circuit model as described above, the diameter of the arc portion Aa of the anode impedance is calculated as the anode resistance Ra of the electrolytic unit 2, and the diameter of the arc portion Ac of the cathode impedance is calculated as the cathode resistance Rc of the electrolytic unit 2. Here, the arc portion Aa of the anode impedance is convex to the negative side of the imaginary component of the impedance, and the imaginary component of the impedance has a negative value at the vertex Ta of the convex shape of the arc portion Aa. The arc portion Ac of the cathode impedance is convex to the negative side of the imaginary component of the impedance, and the imaginary component of the impedance has a negative value at the vertex Tc of the convex shape of the arc portion Ac.

Reference Literature 2 (Japanese Patent Application Laid-Open No. 2017 -106889) discloses a method of calculating a resistance component of a battery by calculating a value of a circuit parameter set in an equivalent circuit model by performing fitting calculation using a measurement result of a frequency characteristic of impedance of the battery and a relationship between the circuit parameter (circuit constant) indicated by the equivalent circuit of the equivalent circuit model of the battery and the impedance. In the approach and the like, the membrane resistance Rm, the anode resistance Ra, and the cathode resistance Rc of the electrolytic unit 2 may be calculated in the same manner as the calculation of the resistance component for the battery in Reference Literature 2.

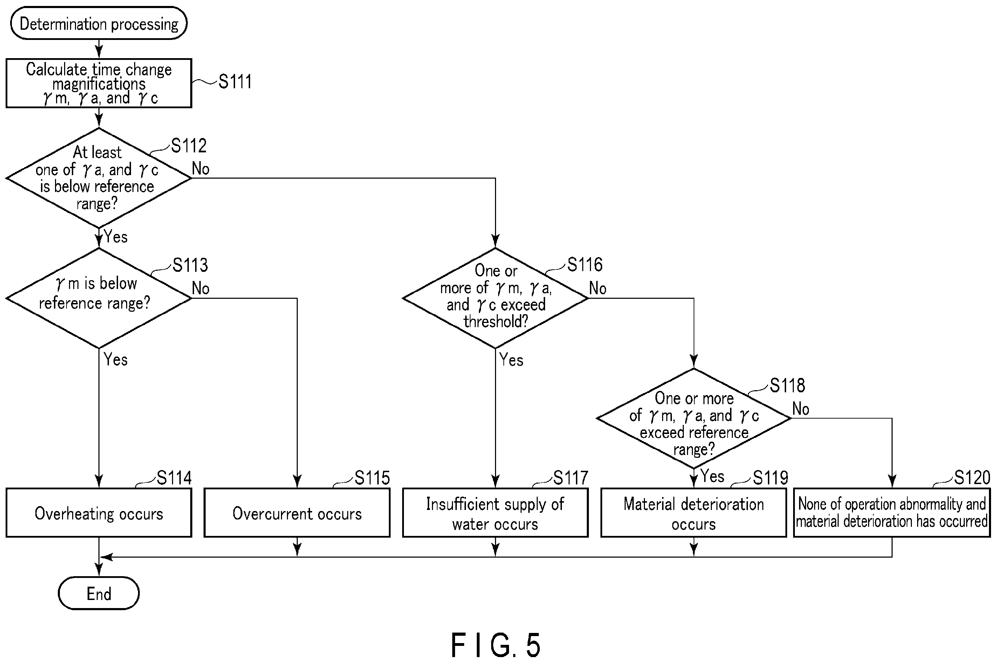

FIG. 5 is a flowchart schematically illustrating an example of determination processing regarding an operation status and a deterioration state of the electrolytic unit 2 performed by the processing circuit 21 and the like in the first approach. The determination processing in the example of FIG. 5 is performed after the above-described estimation processing for the resistance component of the electrolytic unit 2 is performed in each diagnosis processing for the electrolytic unit 2 repeatedly performed over time. The determination processing in the example of FIG. 5 is performed based on the estimation results of the membrane resistance Rm, the anode resistance Ra, and the cathode resistance Rc of the electrolytic unit 2 in the resistance component estimation processing.

When the processing of the example of FIG. 5 is started, the processing circuit 21 and the like calculate the time change magnifications γm, γa, and γc as parameters related to the time change for the membrane resistance Rm, the anode resistance Ra, and the cathode resistance Rc of the electrolytic unit 2, respectively (S111). Each of the time change magnifications γm, γa, and γc, which are parameters related to the time change, is calculated as a determination parameter in the determination processing. Here, as the time change magnification γm of the membrane resistance Rm, for example, the ratio of the estimation result of the membrane resistance Rm in the diagnosis processing performed in real time to the estimation result of the membrane resistance Rm in the previous diagnosis processing is calculated as the final value. In a case where the membrane resistance Rm is unchanged from the previous diagnosis processing, the time change magnification γm is 1. In addition, in a case where the membrane resistance Rm increases from the previous diagnosis processing, the time change magnification γm becomes a value larger than 1, and in a case where the membrane resistance Rm decreases from the previous diagnosis processing, the time change magnification γm becomes a value smaller than 1.

As the time change magnification γa of the anode resistance Ra, for example, a ratio of the estimation result of the anode resistance Ra in the diagnosis processing performed in real time to the estimation result of the anode resistance Ra in the previous diagnosis processing is calculated as the final value. In a case where the anode resistance Ra is unchanged from the previous diagnosis processing, the time change magnification γa is 1. In a case where the anode resistance Ra increases from the previous diagnosis processing, the time change magnification γa becomes a value larger than 1, and in a case where the anode resistance Ra decreases from the previous diagnosis processing, the time change magnification γa becomes a value smaller than 1.

As the time change magnification γc of the cathode resistance Rc, for example, the ratio of the estimation result of the cathode resistance Rc in the diagnosis processing performed in real time to the estimation result of the cathode resistance Rc in the previous diagnosis processing is calculated as the final value. In a case where the cathode resistance Rc is unchanged from the previous diagnosis processing, the time change magnification γc is 1. In a case where the cathode resistance Rc increases from the previous diagnosis processing, the time change magnification γc becomes a value larger than 1, and in a case where the cathode resistance Rc decreases from the previous diagnosis processing, the time change magnification γc becomes a value smaller than 1.

Note that, in one example, in the calculation of the time change magnifications γm, γa, and γc in S111, the processing circuit 21 and the like calculate the final value of the time change magnification by using the calculated value of the time change magnification in each of the latest reference number of times Nref (Nref is a natural number of 2 or more) of diagnosis processing including the diagnosis processing performed in real time as the tentative value. In this case, the processing circuit 21 and the like calculate, for each of the time change magnifications γm, γa, and γc serving as the determination parameters, for example, an average value or an intermediate value of the calculated values in the diagnosis processing of the latest reference number of times Nref as the final value.

In a case where the respective final values of the time change magnifications γm, γa, and γc are calculated in the same manner as in any of the above-described examples, the processing circuit 21 and the like perform the processing in and after S112 using the time change magnifications γm, γa, and γc calculated as the determination parameters. In the processing of the example of FIG. 5, the reference range is set for each of the time change magnifications γm, γa, and γc. The reference range of each of the time change magnifications γm, γa, and γc includes a value in a case where a resistance value of a corresponding one of the resistance components is unchanged over time, that is, 1.

Therefore, the reference range of the time change magnification γm includes a value in a case where the membrane resistance Rm is unchanged over time. That is, the value 1 is included in the reference range of the time change magnification γm equal to or more than the lower limit value γmlow and equal to or less than the upper limit value γmup. Similarly, the reference range of the time change magnification γa includes a value in a case where the anode resistance Ra is unchanged over time. That is, the value 1 is included in the reference range of the time change magnification γa equal to or more than the lower limit value γalow and equal to or less than the upper limit value γaup. The reference range of the time change magnification γc includes a value in a case where the cathode resistance Rc is unchanged over time. That is, the value 1 is included in the reference range of the time change magnification γc equal to or more than the lower limit value γclow and equal to or less than the upper limit value γcup.

In one example, the range of ±Δγm with the value 1 as the median value is the reference range of the time change magnification γm. The range of ±Δγa with the value 1 as the median value is the reference range of the time change magnification γa, and the range of ±Δγc with the value 1 as the median value is the reference range of the time change magnification γc. In this case, the values 1-Δγm and 1+Δγm are the lower limit value γmlow and the upper limit value γmup of the reference range of the time change magnification γm, respectively. The values 1-Δγa and 1+Δγa are the lower limit value γalow and the upper limit value γaup of the reference range of the time change magnification γa, respectively, and the values 1-Δγc and 1+Δγc are the lower limit value γclow and the upper limit value γcup of the reference range of the time change magnification γc, respectively.

In the processing of the example of FIG. 5, when the final values of the time change magnifications γm, γa, and γc are calculated as the determination parameters, the processing circuit 21 and the like compare the calculation result by the processing of S111 with the reference range set as described above for each of the time change magnifications γm, γa, and γc. That is, the processing circuit 21 and the like compare the calculation result of the determination parameter, which is a parameter related to the time change, with respect to the reference range for each of the membrane resistance Rm, the anode resistance Ra, and the cathode resistance Rc. Then, the processing circuit 21 and the like determine whether or not at least one of the time change magnifications γa and γc is below the reference range (S112). At this time, the processing circuit 21 and the like determine whether or not the time change magnification γa of the anode resistance Ra is smaller than the lower limit value γalow of the reference range and whether or not the time change magnification γc of the cathode resistance Rc is smaller than the lower limit value γclow of the reference range.

In a case where at least one of the time change magnifications γa and γc is below the reference range (S112-Yes), that is, in a case where at least one of the time change magnifications γa and γc is smaller than the lower limit value of the reference range (γalow; yclow), the processing circuit 21 and the like determines whether or not the time change magnification γm is below the reference range (S113). At this time, the processing circuit 21 and the like determine whether or not the time change magnification γm of the membrane resistance Rm is smaller than the lower limit value γmlow of the reference range.

In a case where the time change magnification γm is below the reference range (S113-Yes), that is, in a case where the time change magnification γm is smaller than the lower limit value γmlow of the reference range, the processing circuit 21 and the like determine that overheating has occurred in the electrolytic unit 2 (S114). On the other hand, in a case where the time change magnification γm is not below the reference range (S113-No), that is, in a case where the time change magnification γm is equal to or more than the lower limit value γmlow of the reference range, the processing circuit 21 and the like determine that an overcurrent is generated in the electrolytic unit 2 (S115).

In the example of FIG. 5, by performing the processing in the order of S112, S113, and S114, the processing circuit 21 and the like determine that overheating has occurred in the electrolytic unit 2 based on the fact that the time change magnification (γa; γc) of at least one of the anode resistance Ra and the cathode resistance Rc is below the reference range and the time change magnification γm of the membrane resistance Rm is below the reference range. Then, by performing the processing in the order of S112, S113, and S115, the processing circuit 21 and the like determine that an overcurrent has occurred in the electrolytic unit 2 based on the fact that the time change magnification (γa; γc) of at least one of the anode resistance Ra and the cathode resistance Rc is below the reference range and the time change magnification γm of the membrane resistance Rm is not below the reference range. Therefore, it is determined whether or not at least one of overheating and overcurrent has occurred in the electrolytic unit 2 by the determination in S112. By the determination in S113, it is determined whether overheating or overcurrent has occurred in the electrolytic unit 2.

In the processing of the example of FIG. 5, thresholds γmth, γath, and γcth are set for the time change magnifications γm, γa, and γc which are determination parameters, respectively. For each of the time change magnifications γm, γa, and γc, a threshold (γmth; γath; γcth) is set higher than the reference range. Therefore, regarding the time change magnification γm of the membrane resistance Rm, the threshold γmth is set to be larger than the upper limit value γmup of the reference range. Similarly, regarding the time change magnification γa of the anode resistance Ra, the threshold γath is set to be larger than the upper limit value γaup of the reference range, and regarding the time change magnification γc of the cathode resistance Rc, the threshold γcth is set to be larger than the upper limit value γcup of the reference range.

In S112, in a case where none of the time change magnifications γa and γc is below the reference range (S112-No), the processing circuit 21 and the like determine whether or not one or more of the time change magnifications γm, γa, and γc exceed a threshold (γmth; γath; γcth) (S116). At this time, the processing circuit 21 and the like compare the calculation result by the processing of S111 with respect to thresholds (γmth; γath; γcth) for the time change magnifications (γm; γa; γc) of the membrane resistance Rm, the anode resistance Ra, and the cathode resistance Rc, and determine whether or not the calculation result is larger than the threshold (γmth; γath; γcth). That is, the processing circuit 21 and the like determine whether or not the time change magnification γm exceeds the threshold γmth, whether or not the time change magnification γa exceeds the threshold γath, and whether or not the time change magnification γc exceeds the threshold γcth.

In a case where one or more of the time change magnifications γm, γa, and γc exceed the threshold (γmth; γath; γcth) (S116-Yes), the processing circuit 21 and the like determine that insufficient supply of water as a feed has occurred in the electrolytic unit 2 (S117). In the example of FIG. 5, by performing the processing in the order of S112, S116, and S117, the processing circuit 21 and the like determine that insufficient supply of water (feed) has occurred in the electrolytic unit 2 based at least on the fact that the time change magnifications (γm; γa; γc) of one or more of the membrane resistance Rm, the anode resistance Ra, and the cathode resistance Rc exceed the threshold. Therefore, in a case where none of the time change magnifications γa and γc is not below the reference range in S112 (S112-No), that is, in a case where neither overheating nor overcurrent occurs in the electrolytic unit 2, it is determined whether insufficient supply of water has occurred in the electrolytic unit 2 by the determination in S116.

In a case where all of the time change magnifications γm, γa, and γc are equal to or less than the threshold (γmth; γath; γcth) (S116-No), the processing circuit 21 and the like determine whether or not one or more of the time change magnifications γm, γa, and γc exceed the reference range (S118). At this time, the processing circuit 21 and the like determine, for the time change magnifications (γm; γa; γc) of the membrane resistance Rm, the anode resistance Ra, and the cathode resistance Rc, whether or not the time change magnifications are larger than the upper limit values (γmup; γaup; γcup) of the reference range, respectively. That is, the processing circuit 21 and the like determine whether or not the time change magnification γm exceeds the upper limit value γmup of the reference range, whether or not the time change magnification γa exceeds the upper limit value γaup of the reference range, and whether or not the time change magnification γc exceeds the upper limit value γcup of the reference range.

In a case where one or more of the time change magnifications γm, γa, and γc exceed the reference range (S118-Yes), that is, in a case where one or more of the time change magnifications γm, γa, and γc are larger than the upper limit values (γmup; γaup; γcup) of the reference range, the processing circuit 21 and the like determine that material degradation has occurred in the electrolytic unit 2 (S119). On the other hand, when none of the time change magnifications γm, γa, and γc exceed the reference range (S118-No), that is, when all of the time change magnifications γm, γa, and γc are equal to or smaller than the upper limit values (γmup; γaup; γcup) of the reference range, the processing circuit 21 and the like determine that neither operation abnormality nor material deterioration has occurred in the electrolytic unit 2 (S120).

In the example of FIG. 5, by performing the processing in the order of S112, S116, S118, and S119, the processing circuit 21 and the like determine that material deterioration has occurred in the electrolytic unit 2 based at least on the fact that the time change magnifications (γm; γa; γc) of one or more of the membrane resistance Rm, the anode resistance Ra, and the cathode resistance Rc exceed the reference range, and the time change magnification (γm; γa; γc) of any one of the membrane resistance Rm, the anode resistance Ra, and the cathode resistance Rc is also equal to or less than the threshold. Therefore, in a case where none of the time change magnifications γa and γc is below the reference range in S112, that is, in a case where neither overheating nor overcurrent has occurred in the electrolytic unit 2, it is determined whether material deterioration has occurred in the electrolytic unit 2 by the determination in S116 and the determination in S118.

By performing the processing of the example of FIG. 5, the processing circuit 21 and the like compare, for the time change magnifications (γm; γa; γc) of the membrane resistance Rm, the anode resistance Ra, and the cathode resistance Rc of the electrolytic unit 2, the calculation result in the real-time diagnosis processing with respect to the reference range including a value in a case where the resistance value is unchanged over time, and thereby determine the operation status and the deterioration state of the electrolytic unit 2. Therefore, by performing the processing of the example of FIG. 5, the processing circuit 21 and the like determine the operation status and the deterioration state of the electrolytic unit 2 based on the time changes of the membrane resistance Rm, the anode resistance Ra, and the cathode resistance Rc.

Here, in the electrolytic unit 2, when the temperature rises, the resistance components including the membrane resistance Rm, the anode resistance Ra, and the cathode resistance Rc decrease according to Arrhenius' law. Therefore, when the overheating occurs in the electrolytic unit 2, the time change magnifications (γm; γa; γc) of the membrane resistance Rm, the anode resistance Ra, and the cathode resistance Rc with respect to the state in which the overheating has not occurred tend to be below the reference range.

As the current increases, in each of the electrolytic cells 3, the anode resistance Ra and the cathode resistance Rc decrease since the catalyst activity of each of the anode and the cathode increases in accordance with the Butler Volmer equation. On the other hand, since the membrane resistance Rm is a resistance component that does not follow the Butler Volmer equation, the membrane resistance Rm does not change or hardly changes even if the current increases. Therefore, when the overcurrent occurs in the electrolytic unit 2, the time change magnifications (γa; γc) of the anode resistance Ra and the cathode resistance Rc with respect to the state in which the overcurrent has not occurred tend to be below the reference range. Even if an overcurrent occurs in the electrolytic unit 2, the time change magnification γm of the membrane resistance Rm with respect to a state in which the overcurrent has not occurred is 1 or substantially 1, and tends to fall within the reference range.

In the present approach, it is determined whether or not the time change magnifications (γa;γc) of the anode resistance Ra and the cathode resistance Rc are below the reference range, respectively. In a case where the time change magnification (γa;γc) of at least one of the anode resistance Ra and the cathode resistance Rc is below the reference range, it is determined whether or not the time change magnification γm of the membrane resistance Rm is below the reference range. In a case where the time change magnification γm of the membrane resistance Rm is below the reference range, it is determined that the overheating has occurred in the electrolytic unit 2, and in a case where the time change magnification γm of the membrane resistance Rm is not below the reference range, it is determined that the overcurrent has occurred in the electrolytic unit 2. Since such a determination is made, the occurrence of each of the overheating and the overcurrent is appropriately determined and grasped in the electrolytic unit 2.

In addition, in the electrolytic unit 2, when the supply amount of water as a feed decreases, the reaction rate of electrolysis of water decreases, so that the resistance components including the membrane resistance Rm, the anode resistance Ra, and the cathode resistance Rc tend to rapidly increase in a short time. Therefore, when insufficient supply of water occurs in the electrolytic unit 2, the time change magnifications (γm; γa; γc) of the membrane resistance Rm, the anode resistance Ra, and the cathode resistance Rc with respect to the state in which the insufficient supply of water has not occurred tend to exceed thresholds (γmth; γath; γcth).

In addition, in the electrolytic unit 2, even if material deterioration occurs, one or more of resistance components including the membrane resistance Rm, the anode resistance Ra, and the cathode resistance Rc tend to increase. However, in a case where the material deterioration has occurred, the resistance component tends to gradually increase over time as compared with the case where the insufficient supply of water has occurred. That is, in a case where the material deterioration has occurred, the time increase rate of the resistance component tends to be lower as compared with the case where the insufficient supply of water has occurred. Therefore, even if material deterioration occurs in the electrolytic unit 2 and any one or more of the membrane resistance Rm, the anode resistance Ra, and the cathode resistance Rc increases over time, the time change magnification (corresponding one or more of γm, γa, and γc) of the increased resistance components tend to exceed the reference range but to be equal to or less than the threshold.

In the present approach, in a case where the time change magnification (γa;γc) of any one of the anode resistance Ra and the cathode resistance Rc is also not below the reference range, it is determined whether or not the time change magnifications (γm;γa;γc) of the membrane resistance Rm, the anode resistance Ra, and the cathode resistance Rc exceed the thresholds (γmth; γath; γcth) set to be higher than the reference range. Then, in a case where the time change magnifications (γm; γa; γc) of one or more of the membrane resistance Rm, the anode resistance Ra, and the cathode resistance Rc exceed the thresholds (γmth; γath; γcth), it is determined that the insufficient supply of water (feed) has occurred in the electrolytic unit 2. Since such a determination is made, the occurrence of insufficient supply of water as a feed is appropriately determined and grasped in the electrolytic unit 2.

Further, in the present approach, in a case where the time change magnification (γa;γc) of any one of the anode resistance Ra and the cathode resistance Rc is also not below the reference range, it is determined whether or not the time change magnifications (γm;γa;γc) of the membrane resistance Rm, the anode resistance Ra, and the cathode resistance Rc exceed the thresholds (γmth; γath; γcth) and whether or not the time change magnifications exceed the reference range, respectively. Then, in a case where the time change magnifications (γm; γa; γc) of one or more of the membrane resistance Rm, the anode resistance Ra, and the cathode resistance Rc exceed the reference range, and the time change magnification (γm; γa; γc) of any one of the membrane resistance Rm, the anode resistance Ra, and the cathode resistance Rc is also equal to or less than the threshold (γmth; γath; γcth), it is determined that material deterioration has occurred in the electrolytic unit 2. Since such a determination is made, the occurrence of material deterioration is appropriately determined and grasped in the electrolytic unit 2.

As described above, in the present approach, by performing the determination processing of the example of FIG. 5, the operation status and the deterioration state of the electrolytic unit 2 are determined based on the time changes of the membrane resistance Rm, the anode resistance Ra, and the cathode resistance Rc. Then, by the determination processing based on the time change of the resistance component, the occurrence of the operation abnormality in the electrolytic unit 2 such as the overheating, the overcurrent, and the insufficient supply of feed can be appropriately grasped. By the determination processing based on the time change of the resistance component, the occurrence of material deterioration in the electrolytic unit 2 can be appropriately grasped. Therefore, in the present approach, the deterioration state and the operation status of the electrolytic unit 2 can be appropriately grasped by the determination processing based on the time change of the resistance component.

In addition, by grasping the occurrence of the operation abnormality in the electrolytic unit 2, the user or the like of the operation system 1 can grasp, for example, a component or the like having a possibility of failure in the operation system 1. For example, in a case where it is determined that overheating has occurred in the electrolytic unit 2, it can be grasped that there is a possibility that the temperature sensor 17 has failed. In a case where it is determined that an overcurrent has occurred in the electrolytic unit 2, it can be grasped that there is a possibility that the current measurement circuit 7 (current sensor) has failed. In a case where it is determined that insufficient supply of feed has occurred in the electrolytic unit 2, it can be grasped that there is a possibility that the supply pump 12 has failed.

### (Verification related to first approach)

Here, the following verification was performed as verification related to the first approach. In the verification, six electrolytic units β1 to β6, which are water electrolysis units, were determined. As electrolytic units β1 to β6, water electrolysis units in which at least one of an operation status and a deterioration state is different from each other were used.

In the verification, the membrane resistance Rm, the anode resistance Ra, and the cathode resistance Rc were estimated at a plurality of time points for each of the electrolytic units β1 to β6. Then, for each of the electrolytic units β1 to β6, time change magnifications γm, γa, and γc were calculated as parameters related to time changes of the membrane resistance Rm, the anode resistance Ra, and the cathode resistance Rc, respectively. Estimation of the membrane resistance Rm, the anode resistance Ra, and the cathode resistance Rc, and calculation of the time change magnifications γm, γa, and γc were performed as described above in the first approach. Then, for each of the electrolytic units β1 to β6, the operation status and the deterioration state were determined using the calculation results of the time change magnifications γm, γa, and γc, similarly to the determination processing of the example of FIG. 5.

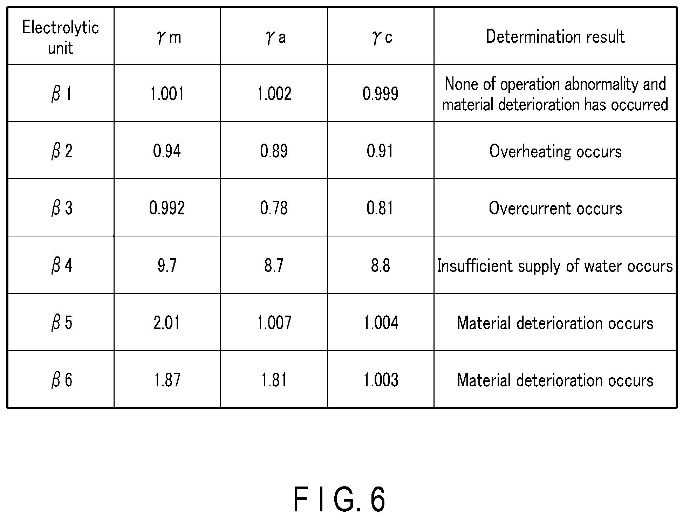

FIG. 6 is a schematic diagram illustrating a verification result in verification related to the first approach and the like. In FIG. 6, for each of the six electrolytic units β1 to β6, calculation results of the time change magnifications (γm; γa; γc) of the membrane resistance Rm, the anode resistance Ra, and the cathode resistance Rc, and the determination results regarding the operation status and the deterioration state are shown in a table. As shown in FIG. 6, the time change magnification γm of the membrane resistance Rm was 1.001, 0.940, 0.992, 9.7, 2.01, and 1.87 in the electrolytic units β1 to β6, respectively. The time change magnification γa of the anode resistance Ra was 1.002, 0.890, 0.780, 8.7, 1.007, and 1.81 in the electrolytic units β1 to β6, respectively, and the time change magnification γc of the cathode resistance Rc was 0.999, 0.910, 0.810, 8.8, 1.004, and 1.003 in the electrolytic units β1 to β6, respectively.

Further, in the determination related to the operation status and the deterioration state of each of the electrolytic units β1 to β6, for each of the time change magnifications γm, γa, and γc, a range of 0.99 or more and 1.11 or less is set as a reference range, and 3.0 is set as a threshold (γmth; γath; γcth). The same determination as the determination processing in the example of FIG. 5 was made on each of the electrolytic units β1 to β6. The electrolytic unit β1 was determined in the order of S112-No, S116-No, and S118-No, and in S120, it is determined that neither operation abnormality nor material deterioration has occurred in the electrolytic unit β1. The electrolytic unit β2 was determined in the order of S112-Yes and S113-Yes, and it is determined in S114 that the overheating has occurred in the electrolytic unit β2. In the electrolytic unit β2, in response to the occurrence of the overheating, the time change magnifications γm, γa, and γc, which are parameters related to the time change of the resistance component, showed the tendency described above in the first approach.

The electrolytic unit β3 was determined in the order of S112-Yes and S113-No, and it is determined in S115 that an overcurrent has occurred in the electrolytic unit β3. In the electrolytic unit β3, in response to the occurrence of the overcurrent, the time change magnifications γm, γa, and γc, which are parameters related to the time change of the resistance component, showed the tendency described above in the first approach. The electrolytic unit β4 was determined in the order of S112-No and S116-Yes, and it is determined in S117 that insufficient supply of water has occurred in the electrolytic unit β4. In the electrolytic unit β4, in response to the occurrence of the insufficient supply of water, the time change magnifications γm, γa, and γc, which are parameters related to the time change of the resistance component, showed the tendency described above in the first approach.

The electrolytic units β5 and β6 were determined in the order of S112-No, S116-No, and S118-Yes, and it is determined in S119 that material deterioration has occurred in each of the electrolytic units β5 and β6. In each of the electrolytic units β5 and β6, in response to the deterioration of the material, the time change magnifications γm, γa, and γc, which are parameters related to the time change of the resistance component, showed the tendency described above in the first approach. In the electrolytic unit β5, since only the time change magnification γm of the membrane resistance Rm exceeds the reference range and is equal to or less than the threshold γmth, it is determined that material deterioration has occurred in the membrane in the electrolytic unit β5. In addition, in the electrolytic unit β6, the time change magnification γm of the membrane resistance Rm and the time change magnification γa of the anode resistance Ra exceed the reference range, and are equal to or less than the thresholds (γmth; γath), so that it is determined that material deterioration has occurred in each of the membrane and the anode for the electrolytic unit β6.

### (Modification)

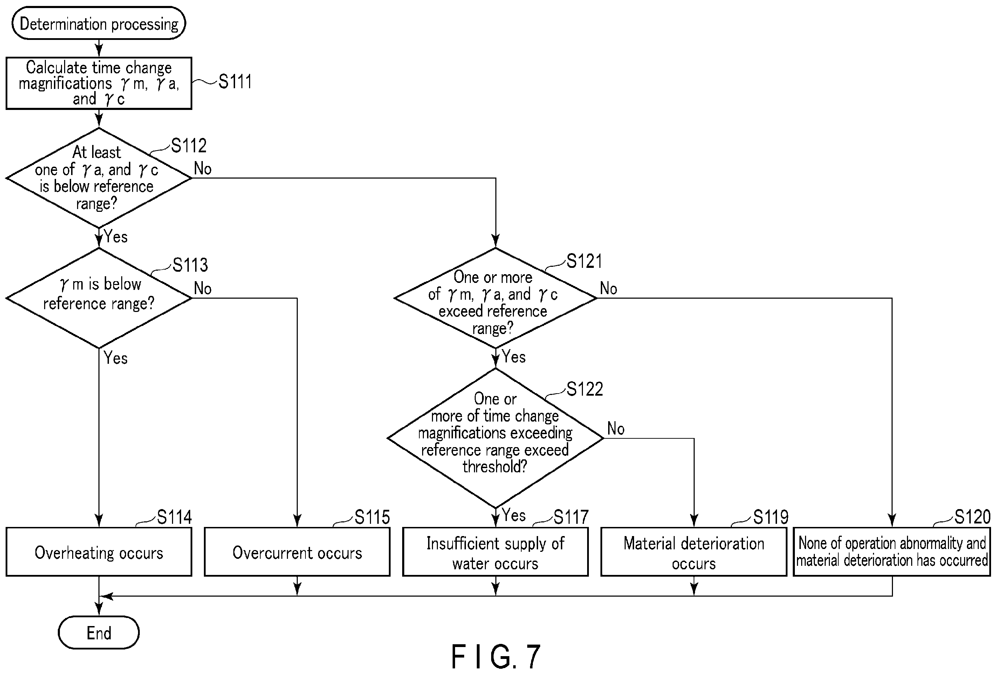

Hereinafter, modifications of the above-described approach and the like will be described. FIG. 7 is a flowchart schematically illustrating an example of determination processing regarding an operation status and a deterioration state of the electrolytic unit 2 performed by the processing circuit 21 and the like in the first modification. Also in the determination processing of the example of FIG. 7, the processing of S111 to S115 is performed similarly to the determination processing of the example of FIG. 5 of the above-described approach and the like. However, in the present modification, in a case where none of the time change magnifications γa and γc is below the reference range in S112 (S112-No), the processing circuit 21 and the like determine whether or not one or more of the time change magnifications γm, γa, and γc exceed the reference range (S121). Then, in a case where none of the time change magnifications γm, γa, and γc exceeds the reference range, that is, in a case where all of the time change magnifications γm, γa, and γc are equal to or less than the upper limit value of the reference range (γmup; γaup; γcup) (S121-No), the processing circuit 21 and the like determine that neither operation abnormality nor material deterioration has occurred in the electrolytic unit 2 (S120).

In the processing of the example of FIG. 7, in a case where one or more of the time change magnifications γm, γa, and γc exceed the reference range (S121-yes), the processing circuit 21 and the like determine whether or not the time change magnifications (one or more of γm, γa, and γc) exceeding the reference range exceed the thresholds (γmth; γath; γcth). Then, the processing circuit 21 and the like determine whether or not one or more of the time change magnifications (one or more of γm, γa, and γc) exceeding the reference range exceed the thresholds (γmth; γath; γcth) (S122). In a case where one or more of the time change magnifications (one or more of γm, γa, γc) exceeding the reference range also exceed thresholds (γmth; γath; γcth) (S122-Yes), the processing circuit 21 and the like determine that insufficient supply of water has occurred in the electrolytic unit 2 (S117). In addition, in a case where all of the time change magnifications (one or more of γm, γa, and γc) exceeding the reference range are equal to or less than the thresholds (γmth; γath; γcth) (S122-No), the processing circuit 21 and the like determine that material deterioration has occurred in the electrolytic unit 2 (S118).

Also in the present modification, similarly to the above-described approach and the like including the processing of the example of FIG. 5, in a case where the time change magnification (γa; γc) of any one of the anode resistance Ra and the cathode resistance Rc is also not below the reference range, it is determined whether or not the time change magnifications (γm; γa; γc) of the membrane resistance Rm, the anode resistance Ra, and the cathode resistance Rc exceed the thresholds (γmth; γath; γcth) and whether or not the time change magnifications exceed the reference range. Also in the present modification, determination is made with respect to an operation status and a deterioration state of the electrolytic unit 2 based on respective time changes of the membrane resistance Rm, the anode resistance Ra, and the cathode resistance Rc. Therefore, the present modification also achieves the same operations and effects as those of the above-described approach and the like. That is, also in the present modification, the occurrence of the operation abnormality in the electrolytic unit 2 such as the overheating, the overcurrent, and the insufficient supply of a feed can be appropriately grasped by the determination processing based on the time change of the resistance component.

Determination similar to the determination processing in the example of FIG. 7 is made on each of the electrolytic units β1 to β6 illustrated in FIG. 6, so that the electrolytic unit β1 is determined in the order of S112-No and S121-No, and it is determined in S120 that neither the operation abnormality nor the material deterioration has occurred in the electrolytic unit β1. In addition, each of the electrolytic units β2 and β3 was determined in the same manner as in the case of performing the determination processing of the example of FIG. 5. The electrolytic unit β4 was determined in the order of S112-No, S121-Yes, and S122-Yes, and it is determined in S117 that the insufficient supply of water has occurred in the electrolytic unit β4. Then, each of the electrolytic units β5 and β6 was determined in the order of S112-No, S121-Yes, and 122-No, and it is determined that material deterioration has occurred in each of the electrolytic units β5 and β6.

In the second modification, for the membrane resistance Rm, the anode resistance Ra, and the cathode resistance Rc of the electrolytic unit 2, time change amounts εm, εa, and εc of are calculated as parameters related to time change instead of the time change magnifications γm, γa, and γc, respectively. In the present modification, each of the time change amounts εm, εa, and εc, which are parameters related to time change, is calculated as a determination parameter in the determination processing.

Here, as the time change amount εm of the membrane resistance Rm, for example, an increment or a decrement of the membrane resistance Rm from the previous diagnosis processing to the diagnosis processing performed in real time is calculated as a final value. At this time, for example, in the k-th diagnosis processing, a subtraction value obtained by subtracting the estimation result of the membrane resistance Rm in the k-1th diagnosis processing from the estimation result of the membrane resistance Rm in the k-th diagnosis processing is calculated. Then, the time change amount εm is calculated by dividing the calculated subtraction value by the estimation result of the membrane resistance Rm in the k-th diagnosis processing. In a case where the membrane resistance Rm is unchanged from the previous diagnosis processing, the time change amount εm is 0. In a case where the membrane resistance Rm increases from the previous diagnosis processing, the time change amount εm becomes a positive value (a value larger than 0), and in a case where the membrane resistance Rm decreases from the previous diagnosis processing, the time change amount εm becomes a negative value (a value smaller than 0).

The time change amount εa is defined in the same manner as the time change amount εm, for example, by using the anode resistance Ra instead of the membrane resistance Rm. The time change amount εc is defined in the same manner as the time change amount εm, for example, by using the cathode resistance Rc instead of the membrane resistance Rm. Note that, in one example, in the calculation of the time change amounts εm, εa, and εc, the processing circuit 21 and the like calculate a final value of the time change amount by using, as a tentative value, a calculated value of the time change amount in each of the latest reference number of times Nref (Nref is a natural number of 2 or more) of diagnosis processing including diagnosis processing performed in real time. In this case, the processing circuit 21 and the like calculates, for each of the time change amounts εm, εa, and εc, for example, an average value or an intermediate value of the calculated values in the diagnosis processing of the latest reference number of times Nref as the final value.

In the present modification, a reference range is set for each of the time change amounts εm, εa, and εc. The reference range of each of the time change amounts εm, εa, and εc includes a value in a case where a resistance value of a corresponding one of the resistance components is unchanged over time, that is, 0. Therefore, the reference range of the time change amount εm includes a value in a case where the membrane resistance Rm is unchanged over time. That is, the value 0 is included in the reference range of the time change amount εm equal to or more than the lower limit value εmlow and equal to or less than the upper limit value εmup. Similarly, the value 0 is included in the reference range of the time change amount εa equal to or more than the lower limit value εalow and equal to or less than the upper limit value εaup, and the value 0 is included in the reference range of the time change amount εc equal to or more than the lower limit value εclow and equal to or less than the upper limit value εcup. In one example, a range of ±Δεm having a median value of 0 is a reference range of the time change amount εm, a range of ±Δεa having a median value of 0 is a reference range of the time change amount εa, and a range of ±Δεc having a median value of 0 is a reference range of the time change amount εc.

In addition, in the present modification, thresholds εmth, εath, and εcth are set for the time change amounts εm, εa, and εc, respectively. For each of the time change amounts εm, εa, and εc, a threshold (εmth; εath; εcth) is set higher than the reference range, and set larger than the upper limit value (εmup; εaup; εcup) of the reference range.

In the present modification, instead of the time change magnifications γm, γa, and γc, for time change amounts (εm; εa; εc) of the membrane resistance Rm, the anode resistance Ra, and the cathode resistance Rc of the electrolytic unit 2, the processing circuit 21 and the like compare a calculation result in the real-time diagnosis processing with respect to a reference range including a value (that is, 0) in a case where the resistance value is unchanged over time, and thereby determine an operation status and a deterioration state of the electrolytic unit 2. Further, in the determination with respect to the operation status and the deterioration state of the electrolytic unit 2, the processing circuit 21 and the like compare, for each of the time change amounts εm, εa, and εc, a calculation result in the real-time diagnosis processing with respect to a threshold (εmth; εath; εcth) set to be higher than the reference range. In the determination related to the operation status and the deterioration state of the electrolytic unit 2, processing similar to any of the above-described examples is performed, and for example, processing similar to S111 to S120 in the example of FIG. 5 or processing similar to S111 to S115, S117, and S119 to S122 in the example of FIG. 7 is performed.

By performing the determination processing as described above, in the present modification, it is determined whether or not the time change amounts (εa; εc) of the anode resistance Ra and the cathode resistance Rc are below the reference range, respectively. Then, in a case where the time change amount (εa;εc) of at least one of the anode resistance Ra and the cathode resistance Rc is below the reference range, it is determined whether or not the time change amount εm of the membrane resistance Rm is below the reference range. In a case where the time change amount εm of the membrane resistance Rm is below the reference range, it is determined that overheating has occurred in the electrolytic unit 2, and in a case where the time change amount εm of the membrane resistance Rm is not below the reference range, it is determined that overcurrent has occurred in the electrolytic unit 2. Therefore, also in the present modification, similarly to the above-described approach and the like, the occurrence of each of the overheating and the overcurrent is appropriately determined and grasped in the electrolytic unit 2.

In addition, in the present modification, in a case where the time change amount (εa; εc) of any one of the anode resistance Ra and the cathode resistance Rc is not below the reference range, it is determined whether or not the time change amount (εm; εa; εc) of each of the membrane resistance Rm, the anode resistance Ra, and the cathode resistance Rc exceeds a threshold (εmth; εath; εcth) set to be higher than the reference range. Then, in a case where the time change amounts (εm;εa;εc) of one or more of the membrane resistance Rm, the anode resistance Ra, and the cathode resistance Rc exceed the thresholds (εmth; εath; εcth), it is determined that insufficient supply of water (feed) has occurred in the electrolytic unit 2. Therefore, also in the present modification, similarly to the above-described approach and the like, occurrence of insufficient supply of water as a feed is appropriately determined and grasped in the electrolytic unit 2.

In addition, in the present modification, in a case where the time change amount (εa; εc) of any one of the anode resistance Ra and the cathode resistance Rc is not below the reference range, it is determined whether or not the time change amount (εm; εa; εc) of each of the membrane resistance Rm, the anode resistance Ra, and the cathode resistance Rc exceeds a threshold (εmth; εath; εcth) and whether or not the time change amount exceeds the reference range. Then, in a case where the time change amounts (εm;εa;εc) of one or more of the membrane resistance Rm, the anode resistance Ra, and the cathode resistance Rc exceed the reference range, and the time change amount (εm;εa;εc) of any one of the membrane resistance Rm, the anode resistance Ra, and the cathode resistance Rc is also equal to or less than the threshold (εmth; εath; εcth), it is determined that material deterioration has occurred in the electrolytic unit 2. Therefore, also in the present modification, similarly to the above-described approach and the like, occurrence of material deterioration is appropriately determined and grasped in the electrolytic unit 2.

As described above, also in the present modification, the processing circuit 21 and the like determine the operation status and the deterioration state of the electrolytic unit 2 based on the time changes of the membrane resistance Rm, the anode resistance Ra, and the cathode resistance Rc. Then, by the determination processing based on the time change of the resistance component, the occurrence of the operation abnormality in the electrolytic unit 2 such as the overheating, the overcurrent, and the insufficient supply of feed can be appropriately grasped. By the determination processing based on the time change of the resistance component, the occurrence of material deterioration in the electrolytic unit 2 can be appropriately grasped. Therefore, also in the present modification, by the determination processing based on the time change of the resistance component, the deterioration state and the operation status of the electrolytic unit 2 can be appropriately grasped.

The parameters related to the time change of the resistance component used as the determination parameters are not limited to the time change magnifications γm, γa, and γc or the time change amounts εm, εa, and εc. In a certain modification, as the determination parameter, a parameter obtained by adding or subtracting a constant to or from each of the time change magnifications γm, γa, and γc or each of the time change amounts εm, εa, and εc may be used, or a parameter obtained by multiplying each of the time change magnifications γm, γa, and γc or each of the time change amounts εm, εa, and εc by a constant may be used. In addition, in a certain modification, a parameter obtained by normalizing each of the time change magnifications γm, γa, and γc or each of the time change amounts εm, εa, and εc may be used as the determination parameter.

In a modification, for each of the membrane resistance Rm, the anode resistance Ra, and the cathode resistance Rc, a sum or a product of a time change magnification (γm; γa; γv) and a time change amount (εm; εa; εc) is used as a determination parameter. In addition, in a certain modification, λm=γm/(γm+γa+γc) for the membrane resistance Rm, λa=γa/(γm+γa+γc) for the anode resistance Ra, and λc=γc/(γm+γa+γc) for the cathode resistance Rc may be used as determination parameters, respectively. ξm=εm/(εm+εa+εc) for the membrane resistance Rm, ξa=εa/(εm+εa+εc) for the anode resistance Ra, and ξc=εc/(εm+εa+εγc) for the cathode resistance Rc are used as determination parameters.

Also in a case where any parameter is used as the determination parameter, the parameter related to the time change is calculated as the determination parameter for each of the membrane resistance Rm, the anode resistance Ra, and the cathode resistance Rc. At this time, for each of the membrane resistance Rm, the anode resistance Ra, and the cathode resistance Rc, any one of a time change magnification (γm; γa; γc), a parameter corresponding to the time change magnification, a time change amount (εm; εa; εc), and a parameter corresponding to the time change amount is calculated as the determination parameter. Then, determination similar to that of the above-described approach and the like is made using the determination parameter, and for example, determination processing similar to that of the example of FIG. 5 or determination processing similar to that of the example of FIG. 7 is performed.

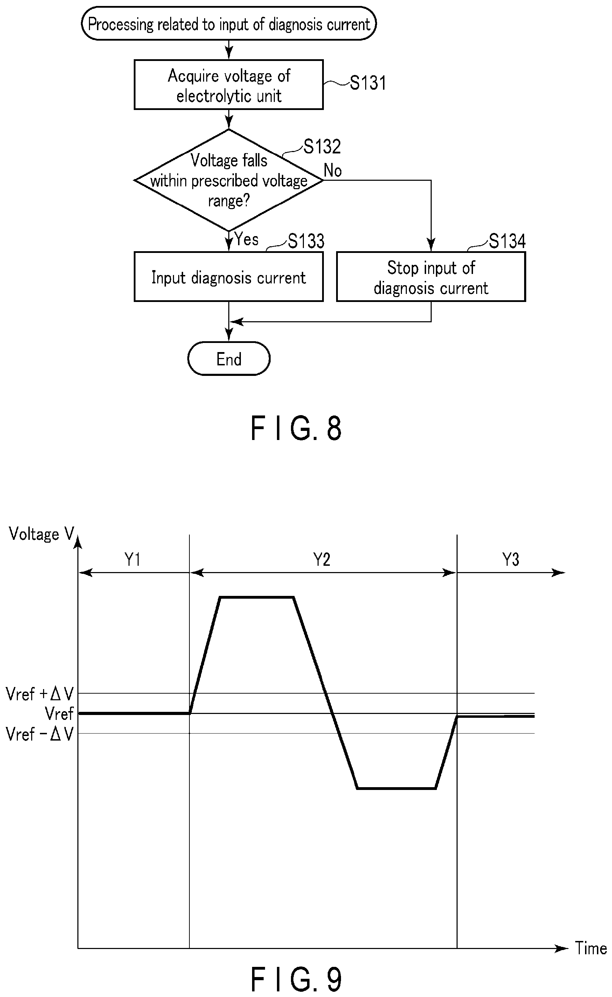

In the third modification, in the measurement of the frequency characteristic of the impedance of the electrolytic unit 2, the timing at which the diagnosis current is input to the electrolytic unit 2 is adjusted as follows. FIG. 8 is a flowchart schematically illustrating an example of processing related to input of a diagnosis current to the electrolytic unit 2, which is performed by the processing circuit 21 and the like in the third modification. The processing in the example of FIG. 8 is repeatedly performed over time when a diagnosis current is input to the electrolytic unit 2 in the estimation processing of the resistance component of the electrolytic unit 2. The processing in the example of FIG. 8 is performed in a state where an operating current is input to the electrolytic unit 2. Therefore, the processing of the example of FIG. 8 is performed in a state where the operating current input to the electrolytic unit 2, the voltage applied to the electrolytic unit 2, and the like are adjusted.

When the processing of the example of FIG. 8 is started, the processing circuit 21 and the like acquire the voltage V of the electrolytic unit 2 in real time as a measurement result by the voltage measurement circuit 8 (S131). Then, the processing circuit 21 and the like determine whether or not the voltage V of the electrolytic unit 2 falls within a prescribed voltage range (S132). In the present modification, for the voltage V of the electrolytic unit 2, the reference voltage Vref in a state where the operating electric power (operating current) is input is set, and a prescribed voltage range including the reference voltage Vref is set. At this time, for example, a range of ±ΔV with the reference voltage Vref as a median value is a prescribed voltage range.

In a case where the voltage V is in the prescribed voltage range (S132-Yes), the processing circuit 21 and the like control the operation of the electric power supply circuit 28 to input a diagnosis current to the electrolytic unit 2 (S133). As a result, the diagnosis current is superimposed on the operating current input to the electrolytic unit 2. On the other hand, in a case where the voltage V is out of the prescribed voltage range (S132-No), the processing circuit 21 and the like control the operation of the electric power supply circuit 28 to stop the input of the diagnosis current to the electrolytic unit 2 (S134).

By performing the processing of the example of FIG. 8, in the present modification, the processing circuit 21 and the like superimpose the diagnosis current on the operating current input to the electrolytic unit 2 in a state where the voltage V of the electrolytic unit 2 is adjusted to a prescribed voltage range. In the present modification, the frequency characteristic of the impedance of the electrolytic unit 2 is measured using the time-series data indicating the time change (time history) of the current and the voltage of the electrolytic unit 2 in the state where the diagnosis current is superimposed on the operating current. Therefore, the frequency characteristic of the impedance of the electrolytic unit 2 is measured in a state where the diagnosis current is superimposed on the operating current.

FIG. 9 is a schematic diagram illustrating an example of timing at which a diagnosis current is input to the electrolytic unit 2 in the third modification. FIG. 9 shows a graph in which the abscissa axis represents time and the ordinate axis represents the voltage V of the electrolytic unit 2, and shows an example of a time change in the voltage V of the electrolytic unit 2. In the example of FIG. 9, in a period Y1, the voltage V of the electrolytic unit 2 falls within a prescribed voltage range equal to or more than the lower limit value Vref-ΔV and equal to or less than the upper limit value Vref+ΔV. Therefore, in the period Y1, the diagnosis current is input to the electrolytic unit 2, and the diagnosis current is superimposed on the operating current input to the electrolytic unit 2.

In a period Y2 after the period Y1, the voltage V of the electrolytic unit 2 is out of the prescribed voltage range. Therefore, in the period Y2, the input of the diagnosis current to the electrolytic unit 2 is stopped, and the diagnosis current is not superimposed on the operating current input to the electrolytic unit 2. In a period Y3 after the period Y2, the voltage V of the electrolytic unit 2 falls within a prescribed voltage range. Therefore, in the period Y3, the diagnosis current is input to the electrolytic unit 2, and the diagnosis current is superimposed on the operating current input to the electrolytic unit 2.

Also in the present modification, functions and effects similar to those of the above-described approach and the like are obtained. Further, in the present modification, since the diagnosis current is input as described above, the diagnosis current is appropriately input to the electrolytic unit 2 at the timing at which the voltage V falls within the prescribed voltage range even in a case where the magnitude of the operating electric power fluctuates over time. Therefore, the frequency characteristic of the impedance of the electrolytic unit 2 is appropriately measured in parallel with the operation of the electrolytic unit 2.

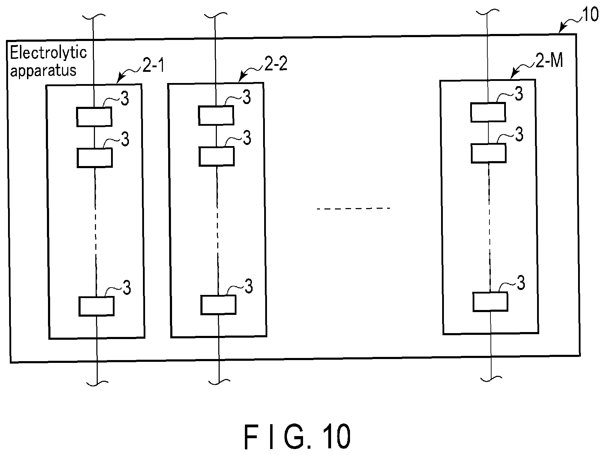

In the fourth modification, in an electrolytic apparatus 10 including a plurality of electrolytic units 2_1 to 2_M, the operation status and the deterioration state of each of the plurality of electrolytic units 2_1 to 2_M are determined in the same manner as in any one of the above-described approaches and the like. FIG. 10 is a schematic view showing a configuration of the electrolytic apparatus 10 according to the fourth modification. As shown in FIG. 10, in the present modification, M electrolytic units 2_1 to 2_M are provided in the electrolytic apparatus 10, and each of the electrolytic units 2_1 to 2_M is constituted by an electrolytic block or an electrolytic module in which a plurality of electrolytic cells 3 are electrically connected.

In the present modification, the processing circuit 21 and the like estimate each of the membrane resistance Rm, the anode resistance Ra, and the cathode resistance Rc based on the measurement result of the frequency characteristic of the impedance for each of the plurality of electrolytic units 2_1 to 2_M of the electrolytic apparatus 10. At this time, the processing circuit 21 and the like estimate the resistance component by, for example, performing the same processing as the example of FIG. 2 for each of the electrolytic units 2_1 to 2_M. In addition, in the present modification, the processing circuit 21 and the like determine an operation status and a deterioration state for each of the plurality of electrolytic units 2_1 to 2_M based on respective time changes of the membrane resistance Rm, the anode resistance Ra, and the cathode resistance Rc. At this time, determination is made in a similar manner to any of the above-described approaches and the like, and for example, determination is made by performing processing similar to the example of FIG. 5 or processing similar to the example of FIG. 7.

Also in the present modification, functions and effects similar to those of the above-described approach and the like are obtained. In the present modification, by the determination processing based on the time change of the resistance component, the deterioration state and the operation status can be appropriately grasped for each of the plurality of electrolytic units 2_1 to 2_M provided in the electrolytic apparatus 10.

In the above-described approach and the like, the case where the water electrolysis unit is used as the electrolytic unit 2 has been described, but the electrolytic unit 2 to be diagnosed is not limited to the water electrolysis unit. In one example, as the electrolytic unit 2, a carbon dioxide electrolysis unit is to be diagnosed. In this case, in the carbon dioxide electrolysis unit to be diagnosed, one or more carbon dioxide electrolysis cells are provided as one or more electrolytic cells 3.

In the carbon dioxide electrolysis cell constituting the carbon dioxide electrolysis unit, water is supplied to the anode and carbon dioxide is supplied to the cathode as a feed. When the operating electric power is input to the carbon dioxide electrolysis unit, in the carbon dioxide electrolysis cell, oxygen is generated from water at the anode, and carbon monoxide is generated from carbon dioxide at the cathode. In this example, in the carbon dioxide electrolysis unit which is the operating electrolytic unit 2, electrolysis of water and carbon dioxide occurs as an electrochemical reaction. Then, oxygen which is a product obtained by electrolysis of water and carbon monoxide which is a product obtained by electrolysis of carbon dioxide are recovered.

When the electrolytic unit 2 is a carbon dioxide electrolytic unit, similarly to any one of the above-described approaches and the like, diagnosis is performed, and determination is made with respect to an operation status and a deterioration state. Therefore, even in the case of the carbon dioxide electrolysis unit which is the electrolytic unit 2, it is possible to appropriately grasp the occurrence of the operation abnormality in the electrolytic unit 2 including the overheating, the overcurrent, and the insufficient supply of the feed. Even in a case where the electrolytic unit 2 is a carbon dioxide electrolysis unit, occurrence of material deterioration in the electrolytic unit 2 can be appropriately grasped.

In the above-described at least one approach or example, for the electrolytic unit, each of the membrane resistance caused by the membrane, the anode resistance caused by the anode, and the cathode resistance caused by the cathode is estimated based on the measurement result of the frequency characteristic of the impedance. Then, based on the time change in each of the membrane resistance, the anode resistance, and the cathode resistance, the operation status and the deterioration state of the electrolytic unit are determined. Accordingly, it is possible to provide a diagnosis method of an electrolytic unit, a diagnosis method of an electrolytic apparatus, a diagnosis apparatus of the electrolytic unit, an operation system, and a diagnosis program of the electrolytic unit that enable appropriate grasping of a deterioration state and an operation status of the electrolytic unit.

The present disclosure also encompasses the following approaches of a diagnosis method of an electrolytic unit, a diagnosis method of an electrolytic apparatus, a diagnosis apparatus of the electrolytic unit, an operation system, and a diagnosis program of the electrolytic unit:
1. A diagnosis method of an electrolytic unit (2) in which an electrochemical reaction using a feed supplied occurs by input of electrical power, the diagnosis method comprising:
   estimating each of a membrane resistance (Rm) caused by a membrane, an anode resistance (Ra) caused by an anode, and a cathode resistance (Rc) caused by a cathode of the electrolytic unit (2) based on a measurement result of a frequency characteristic of impedance; and
   determining an operation status and a deterioration state of the electrolytic unit (2) based on a time change of each of the membrane resistance (Rm), the anode resistance (Ra), and the cathode resistance (Rc).
2. The diagnosis method according to clause 1, in the determining the operation status and the deterioration state of the electrolytic unit (2), further comprising:
   calculating a parameter related to a time change as a determination parameter (γm,γa,γc;εm,εa,εc) for each of the membrane resistance (Rm), the anode resistance (Ra), and the cathode resistance (Rc); and
   comparing a calculation result of the determination parameter (γm,γa,γc;εm,εa,εc) with a reference range including a value in a case where a resistance value is unchanged over time for each of the membrane resistance (Rm), the anode resistance (Ra), and the cathode resistance (Rc).
3. The diagnosis method according to clause 2, in the determining the operation status and the deterioration state of the electrolytic unit (2), further comprising:
   determining that overheating has occurred in the electrolytic unit (2) based on the fact that the determination parameter (γa,γc;εa,εc) of at least one of the anode resistance (Ra) and the cathode resistance (Rc) is below the reference range and the determination parameter (γm;εm)of the membrane resistance (Rm) is below the reference range; and
   determining that an overcurrent has occurred in the electrolytic unit (2) based on the fact that the determination parameter (γa,γc;εa,εc) of at least one of the anode resistance (Ra) and the cathode resistance (Rc) is below the reference range and the determination parameter (γm;εm) of the membrane resistance (Rm) is not below the reference range.
4. The diagnosis method according to clause 3, in the determining the operation status and the deterioration state of the electrolytic unit (2), further comprising:
   determining whether or not the determination parameter (γa,γc;εa,εc) of each of the anode resistance (Ra) and the cathode resistance (Rc) is below the reference range; and
   in a case where the determination parameter (γa,γc;εa,εc) of at least one of the anode resistance (Ra) and the cathode resistance (Rc) is below the reference range, determining whether or not the determination parameter (γm;εm) of the membrane resistance (Rm) is below the reference range, and determining which of the overheating and the overcurrent has occurred in the electrolytic unit (2).
5. The diagnosis method according to any one of clauses 2 to 4, further comprising, in the determining the operation status and the deterioration state of the electrolytic unit (2), determining that an insufficient supply of the feed has occurred in the electrolytic unit (2) based at least on the fact that the determination parameter (γm,γa,γc;εm,εa,εc) of one or more of the membrane resistance (Rm), the anode resistance (Ra), and the cathode resistance (Rc) exceeds a threshold (γmth,γath,γc;εmth,εath,εcth) set higher than the reference range.
6. The diagnosis method according to clause 5, in the determining the operation status and the deterioration state of the electrolytic unit (2), further comprising:
   determining whether or not the determination parameter (γa,γc;εa,εc) of each of the anode resistance (Ra) and the cathode resistance (Rc) is below the reference range; and
   in a case where the determination parameter (γa,γc;εa,εc) of any one of the anode resistance (Ra) and the cathode resistance (Rc) is not below the reference range, determining whether or not the determination parameter (γm,γa,γc;εm,εa,εc) of each of the membrane resistance (Rm), the anode resistance (Ra), and the cathode resistance (Rc) exceeds the threshold (γmth,γath,γc;εmth,εath,εcth), and determining whether or not the insufficient supply of the feed has occurred in the electrolytic unit (2).
7. The diagnosis method according to clause 5, further comprising, in the determining the operation status and the deterioration state of the electrolytic unit (2), determining that material deterioration has occurred in the electrolytic unit (2) based on at least the fact that the determination parameters (γm,γa,γc;εm,εa,εc) of one or more of the membrane resistance (Rm), the anode resistance (Ra), and the cathode resistance (Rc) exceed the reference range, and the determination parameter (γm,γa,γc;εm,εa,εc) of any one of the membrane resistance (Rm), the anode resistance (Ra), and the cathode resistance (Rc) is equal to or less than the threshold (γmth,γath,γc;εmth,εath,εcth).
8. The diagnosis method according to clause 7, in the determining the operation status and the deterioration state of the electrolytic unit (2), further comprising:
   determining whether or not the determination parameter (γa,γc;εa,εc) of each of the anode resistance (Ra) and the cathode resistance (Rc) is below the reference range; and
   in a case where the determination parameter (γa,γc;εa,εc) of any one of the anode resistance (Ra) and the cathode resistance (Rc) is not below the reference range, determining whether or not the determination parameter (γm,γa,γc;εm,εa,εc) of each of the membrane resistance (Rm), the anode resistance (Ra), and the cathode resistance (Rc) exceeds the reference range and whether or not the determination parameter (γm,γa,γc;εm,εa,εc) exceeds the threshold (γmth,γath,γc;εmth,εath,εcth), and determining whether or not the material deterioration has occurred in the electrolytic unit (2).
9. The diagnosis method according to any one of clauses 2 to 8, further comprising, in the determining the operation status and the deterioration state of the electrolytic unit (2), calculating, for each of the membrane resistance (Rm), the anode resistance (Ra), and the cathode resistance (Rc), any one of a time change magnification (γm,γa,γc), a parameter corresponding to the time change magnification (γm,γa,γc), a time change amount (εm,εa,εc), and a parameter corresponding to the time change amount (εm,εa,εc) as the determination parameter.
10. The diagnosis method according to any one of clauses 1 to 9, further comprising:
   adjusting a voltage (V) of the electrolytic unit (2) in a state of operating the electrolytic unit (2);
   superimposing a diagnosis current on an operating current input to the electrolytic unit (2) in a state where the voltage (V) of the electrolytic unit (2) is adjusted to a prescribed voltage range; and
   measuring the frequency characteristic of the impedance of the electrolytic unit (2) in a state where the diagnosis current is superimposed on the operating current.
11. A diagnosis method of an electrolytic apparatus (10) including a plurality of electrolytic units (2) in each of which an electrochemical reaction using a feed supplied occurs by input of electrical power, the diagnosis method comprising:
   determining the operation status and the deterioration state, for each of the electrolytic units (2), by performing the diagnosis method according to any one of clauses 1 to 10 on each of the electrolytic units (2).
12. A diagnosis apparatus (20) of an electrolytic unit (2) in which an electrochemical reaction using a feed supplied occurs by input of electrical power, the diagnosis apparatus (20) comprising a processor that:
   estimates, for the electrolytic unit (2), each of a membrane resistance (Rm) caused by a membrane, an anode resistance (Ra) caused by an anode, and a cathode resistance (Rc) caused by a cathode based on a measurement result of a frequency characteristic of impedance; and
   determines an operation status and a deterioration state of the electrolytic unit (2) based on a time change of each of the membrane resistance (Rm), the anode resistance (Ra), and the cathode resistance (Rc).
13. An operation system (1) comprising:
   the diagnosis apparatus (20) according to clause 12; and
   the electrolytic unit (2) in which a determination regarding the operation status and the deterioration state is made by the processor of the diagnosis apparatus (20).
14. The operation system (1) according to clause 13, further comprising, as the electrolytic unit (2), a plurality of electrolytic units (2) in which an electrochemical reaction using a feed supplied occurs by input of electrical power in each of the electrolytic units (2), wherein
   the processor of the diagnosis apparatus (20) estimates each of the membrane resistance (Rm), the anode resistance (Ra), and the cathode resistance (Rc) based on a measurement result of the frequency characteristic of the impedance for each of the electrolytic units (2), and determines the operation status and the deterioration state based on a time change of each of the membrane resistance (Rm), the anode resistance (Ra), and the cathode resistance (Rc) for each of the electrolytic units (2).
15. A diagnosis program (25) of an electrolytic unit (2) in which an electrochemical reaction using a feed supplied occurs by input of electrical power, the diagnosis program (25) causing a computer to:
   estimate, for the electrolytic unit (2), each of a membrane resistance (Rm) caused by a membrane, an anode resistance (Ra) caused by an anode, and a cathode resistance (Rc) caused by a cathode based on a measurement result of a frequency characteristic of impedance (2); and
   determine an operation status and a deterioration state of the electrolytic unit (2) based on a time change of each of the membrane resistance (Rm), the anode resistance (Ra), and the cathode resistance (Rc).

While certain approaches have been described, these approaches have been presented by way of example only, and are not intended to limit the scope of the inventions. Indeed, the novel approaches described herein may be embodied in a variety of other forms; furthermore, various omissions, substitutions and changes in the form of the approaches described herein may be made without departing from the spirit of the inventions. The accompanying claims and their equivalents are intended to cover such forms or modifications as would fall within the scope and spirit of the inventions.

## Claims

1. A diagnosis method of an electrolytic unit (2) in which an electrochemical reaction using a feed supplied occurs by input of electrical power, the diagnosis method comprising:
estimating each of a membrane resistance (Rm) caused by a membrane, an anode resistance (Ra) caused by an anode, and a cathode resistance (Rc) caused by a cathode of the electrolytic unit (2) based on a measurement result of a frequency characteristic of impedance; and
determining an operation status and a deterioration state of the electrolytic unit (2) based on a time change of each of the membrane resistance (Rm), the anode resistance (Ra), and the cathode resistance (Rc).

2. The diagnosis method according to claim 1, in the determining the operation status and the deterioration state of the electrolytic unit (2), further comprising:
calculating a parameter related to a time change as a determination parameter (γm,γa,γc;εm,εa,εc) for each of the membrane resistance (Rm), the anode resistance (Ra), and the cathode resistance (Rc); and
comparing a calculation result of the determination parameter (γm,γa,γc;εm,εa,εc) with a reference range including a value in a case where a resistance value is unchanged over time for each of the membrane resistance (Rm), the anode resistance (Ra), and the cathode resistance (Rc).

3. The diagnosis method according to claim 2, in the determining the operation status and the deterioration state of the electrolytic unit (2), further comprising:
determining that overheating has occurred in the electrolytic unit (2) based on the fact that the determination parameter (γa,γc;εa,εc) of at least one of the anode resistance (Ra) and the cathode resistance (Rc) is below the reference range and the determination parameter (γm;εm) of the membrane resistance (Rm) is below the reference range; and
determining that an overcurrent has occurred in the electrolytic unit (2) based on the fact that the determination parameter (γa,γc;εa,εc) of at least one of the anode resistance (Ra) and the cathode resistance (Rc) is below the reference range and the determination parameter (γm;εm) of the membrane resistance (Rm) is not below the reference range.

4. The diagnosis method according to claim 3, in the determining the operation status and the deterioration state of the electrolytic unit (2), further comprising:
determining whether or not the determination parameter (γa,γc;εa,εc) of each of the anode resistance (Ra) and the cathode resistance (Rc) is below the reference range; and
in a case where the determination parameter (γa,γc;εa,εc) of at least one of the anode resistance (Ra) and the cathode resistance (Rc) is below the reference range, determining whether or not the determination parameter (γm;εm) of the membrane resistance (Rm) is below the reference range, and determining which of the overheating and the overcurrent has occurred in the electrolytic unit (2).

5. The diagnosis method according to any one of claims 2 to 4, further comprising, in the determining the operation status and the deterioration state of the electrolytic unit (2), determining that an insufficient supply of the feed has occurred in the electrolytic unit (2) based at least on the fact that the determination parameter (γm,γa,γc;εm,εa,εc) of one or more of the membrane resistance (Rm), the anode resistance (Ra), and the cathode resistance (Rc) exceeds a threshold (γmth,γath,γc;εmth,εath,εcth) set higher than the reference range.

6. The diagnosis method according to claim 5, in the determining the operation status and the deterioration state of the electrolytic unit (2), further comprising:
determining whether or not the determination parameter (γa,γc;εa,εc) of each of the anode resistance (Ra) and the cathode resistance (Rc) is below the reference range; and
in a case where the determination parameter (γa,γc;εa,εc) of any one of the anode resistance (Ra) and the cathode resistance (Rc) is not below the reference range, determining whether or not the determination parameter (γm,γa,γc;εm,εa,εc) of each of the membrane resistance (Rm), the anode resistance (Ra), and the cathode resistance (Rc) exceeds the threshold (γmth,γath,γc;εmth,εath,εcth), and determining whether or not the insufficient supply of the feed has occurred in the electrolytic unit (2).

7. The diagnosis method according to claim 5, further comprising, in the determining the operation status and the deterioration state of the electrolytic unit (2), determining that material deterioration has occurred in the electrolytic unit (2) based on at least the fact that the determination parameters (γm,γa,γc;εm,εa,εc) of one or more of the membrane resistance (Rm), the anode resistance (Ra), and the cathode resistance (Rc) exceed the reference range, and the determination parameter (γm,γa,γc;εm,εa,εc) of any one of the membrane resistance (Rm), the anode resistance (Ra), and the cathode resistance (Rc) is equal to or less than the threshold (γmth,γath,γc;εmth,εath,εcth).

8. The diagnosis method according to claim 7, in the determining the operation status and the deterioration state of the electrolytic unit (2), further comprising:
determining whether or not the determination parameter (γa,γc;εa,εc) of each of the anode resistance (Ra) and the cathode resistance (Rc) is below the reference range; and
in a case where the determination parameter (γa,γc;εa,εc) of any one of the anode resistance (Ra) and the cathode resistance (Rc) is not below the reference range, determining whether or not the determination parameter (γm,γa,γc;εm,εa,εc) of each of the membrane resistance (Rm), the anode resistance (Ra), and the cathode resistance (Rc) exceeds the reference range and whether or not the determination parameter (γm,γa,γc;εm,εa,εc) exceeds the threshold (γmth,γath,γc;εmth,εath,εcth), and determining whether or not the material deterioration has occurred in the electrolytic unit (2).

9. The diagnosis method according to any one of claims 2 to 8, further comprising, in the determining the operation status and the deterioration state of the electrolytic unit (2), calculating, for each of the membrane resistance (Rm), the anode resistance (Ra), and the cathode resistance (Rc), any one of a time change magnification (γm,γa,γc), a parameter corresponding to the time change magnification (γm,γa,γc), a time change amount (εm,εa,εc), and a parameter corresponding to the time change amount (εm,εa,εc) as the determination parameter.

10. The diagnosis method according to any one of claims 1 to 9, further comprising:
adjusting a voltage (V) of the electrolytic unit (2) in a state of operating the electrolytic unit (2);
superimposing a diagnosis current on an operating current input to the electrolytic unit (2) in a state where the voltage (V) of the electrolytic unit (2) is adjusted to a prescribed voltage range; and
measuring the frequency characteristic of the impedance of the electrolytic unit (2) in a state where the diagnosis current is superimposed on the operating current.

11. A diagnosis method of an electrolytic apparatus (10) including a plurality of electrolytic units (2) in each of which an electrochemical reaction using a feed supplied occurs by input of electrical power, the diagnosis method comprising:
determining the operation status and the deterioration state, for each of the electrolytic units (2), by performing the diagnosis method according to any one of claims 1 to 10 on each of the electrolytic units (2).

12. A diagnosis apparatus (20) of an electrolytic unit (2) in which an electrochemical reaction using a feed supplied occurs by input of electrical power, the diagnosis apparatus (20) comprising a processor that:
estimates, for the electrolytic unit (2), each of a membrane resistance (Rm) caused by a membrane, an anode resistance (Ra) caused by an anode, and a cathode resistance (Rc) caused by a cathode based on a measurement result of a frequency characteristic of impedance; and
determines an operation status and a deterioration state of the electrolytic unit (2) based on a time change of each of the membrane resistance (Rm), the anode resistance (Ra), and the cathode resistance (Rc).

13. An operation system (1) comprising:
the diagnosis apparatus (20) according to claim 12; and
the electrolytic unit (2) in which a determination regarding the operation status and the deterioration state is made by the processor of the diagnosis apparatus (20).

14. The operation system (1) according to claim 13, further comprising, as the electrolytic unit (2), a plurality of electrolytic units (2) in which an electrochemical reaction using a feed supplied occurs by input of electrical power in each of the electrolytic units (2), wherein
the processor of the diagnosis apparatus (20) estimates each of the membrane resistance (Rm), the anode resistance (Ra), and the cathode resistance (Rc) based on a measurement result of the frequency characteristic of the impedance for each of the electrolytic units (2), and determines the operation status and the deterioration state based on a time change of each of the membrane resistance (Rm), the anode resistance (Ra), and the cathode resistance (Rc) for each of the electrolytic units (2).

15. A diagnosis program (25) of an electrolytic unit (2) in which an electrochemical reaction using a feed supplied occurs by input of electrical power, the diagnosis program (25) causing a computer to:
estimate, for the electrolytic unit (2), each of a membrane resistance (Rm) caused by a membrane, an anode resistance (Ra) caused by an anode, and a cathode resistance (Rc) caused by a cathode based on a measurement result of a frequency characteristic of impedance (2); and
determine an operation status and a deterioration state of the electrolytic unit (2) based on a time change of each of the membrane resistance (Rm), the anode resistance (Ra), and the cathode resistance (Rc).
